(19) Europäisches Patentamt / European Patent Office / Office européen des brevets

(11) **EP 0 762 406 B1**

(12) **EUROPÄISCHE PATENTSCHRIFT**

(45) Veröffentlichungstag und Bekanntmachung des Hinweises auf die Patenterteilung:
**06.06.2007 Patentblatt 2007/23**

(51) Int Cl.:
*G11B 7/24* (2006.01)    *G11B 7/26* (2006.01)
*G11B 11/10* (2006.01)    *C23C 14/06* (2006.01)
*C23C 14/35* (2006.01)

(21) Anmeldenummer: **96113620.7**

(22) Anmeldetag: **26.08.1996**

(54) **Informationsträger und Verfahren zu dessen Herstellung**

Information carrier and manufacturing method thereof

Support d' information et son procédé de fabrication

(84) Benannte Vertragsstaaten:
**CH DE FR GB LI NL**

(30) Priorität: **01.09.1995 CH 249595**
**01.07.1996 US 674019**

(43) Veröffentlichungstag der Anmeldung:
**12.03.1997 Patentblatt 1997/11**

(73) Patentinhaber: **OC Oerlikon Balzers AG**
**9496 Balzers (LI)**

(72) Erfinder: **Kügler, Eduard**
**6800 Feldkirch (DE)**

(74) Vertreter: **Troesch Scheidegger Werner AG**
**Patentanwälte**
**Postfach**
**8032 Zürich (CH)**

(56) Entgegenhaltungen:
**EP-A- 0 086 009      EP-A- 0 368 442**
**EP-A- 0 372 517      EP-A- 0 388 852**
**EP-A- 0 473 492      EP-A- 0 564 789**
**EP-A- 0 592 174      EP-A- 0 658 885**
**EP-A- 0 729 142      WO-A-96/04650**
**US-A- 5 381 401      US-A- 5 414 678**

• **PATENT ABSTRACTS OF JAPAN vol. 008, no. 077 (C-218), 10.April 1984 & JP-A-59 003017 (SHARP KK), 9.Januar 1984,**
• **IBM TECHNICAL DISCLOSURE BULLETIN, Bd. 28, Nr. 1, Juni 1985, NEW YORK, US, Seite 301 XP002001922 ANONYMOUS: "Producing Silicon Carbide Films at Low Temperature"**

EP 0 762 406 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die vorliegende Erfindung betrifft einen Informationsträger nach dem Oberbegriff von Anspruch 1 sowie ein Herstellungsverfahren nach demjenigen von Anspruch 25.

Als Festkörpergrenzfläche verstehen wir den Uebergangsbereich, woran die Oberfläche aus einem Material sich an die Oberfläche aus einem zweiten Material anschmiegt.

In Compact News 1995, "Optical Disc Manufacturing Equipment", sind sog. High Density CDs verschiedener Konstellationen im Ueberblick zusammengestellt.

Als MMCD bzw. "single sided dual layer high density CD" bzw. "hdCD" sind daraus optische Informationsträger bekannt in Form von CDs, bei denen die Informationsdichte wesentlich erhöht ist, dadurch, dass, durch eine Zwischenlage voneinander getrennt, auf einem Trägersubstrat zwei informationstragende Grenzflächen gebildet sind. Die Information ist durch örtliche Modulation von Oberflächen-Einnehmungs-Strukturen an einer die Grenzfläche bildenden Oberfläche aufgebracht. Das Auslesen der Information erfolgt durch einen Strahl elektromagnetischer Strahlung in Form von 635nm bzw. 650nm Laserlicht, insbesondere von 450nm. Die Zwischenlage zwischen den informationstragenden Grenzschichten ist bei diesen Wellenlängen praktisch zu 100% transmittierend, so dass ein Teil der aufgebrachten Strahlungsenergie an der einen informationstragenden Grenzfläche, ein zweiter Teil an der zweiten informationstragenden Grenzfläche reflektiert wird.

Bei den ebenfalls aus obgenanntem Artikel bekannten hybriden MMCD wird die jeweils an den vorgesehenen Grenzflächen aufgebrachte Information selektiv durch je Strahlung mit unterschiedlicher Wellenlänge ausgelesen, nämlich einerseits mittels eines Laserstrahls mit der Lichtwellenlänge von 635nm und andererseits einem Laserstrahl mit 785nm.

Die vorliegende Erfindung bezieht sich unter ihrem weitesten Aspekt auf derartige Informationsträger und ein Verfahren zu deren Herstellung, wobei unter diesem weitesten Aspekt die Information sowohl durch örtliche Modulation der Oberflächenstruktur aufbringbar bzw. aufgebracht sein kann, im Sinne der bekannten optischen Speicherung, oder aber durchaus im Sinne magnetooptischer Speicherung, wie beispielsweise aus der US-5 158 834 bekannt, vorgesehen sein kann. Demnach ist die vorliegende Erfindung unter ihrem breitesten Aspekt nicht auf Informationsträger beschränkt, welche bereits mit Information versehen sind, wie beispielsweise durch Formungsprozesse an optischen Speicherplatten, sondern umfasst durchaus Informationsträger, bei denen die Information erst noch aufzubringen ist.

Aus obgenanntem Artikel sind noch weitere Techniken zur Erhöhung der Informationsdichte an CDs bekannt. Gemäss einem unter dem Kürzel SD "super density" bekannten Ansatz werden zwei Substrate mit je informationsbeaufschlagter Grenzfläche aufeinandergelegt und verbunden. Die Information wird durch 650nm Laserlicht von der Vorder- und der Rückseite ausgelesen. Dadurch, dass gemäss einer Weiterentwicklung der SD zur "dual layer SD" zwischen den sich gegenüberliegenden, informationsstrukturierten Flächen eine für das verwendete Licht transmittierende Zwischenlage vorgesehen ist, wird die Gesamtinformation von einer Seite der Disk auslesbar. Auch auf einen solchen Informationsträger mit durch die erwähnte Zwischenlage getrennten informationbeaufschlagten Grenzflächen bezieht sich die vorliegende Erfindung. Informationsträger, auf die sich die Erfindung bezieht, können somit als

"doppelt- bzw. mehrfachreflektierende" Träger

bezeichnet werden.

Allen gemein ist, dass elektromagnetische Strahlung zum Aufbringen und/oder Auslesen der Information an zwei Grenzschichten bzw. -flächen teilweise an einer ersten Grenzfläche reflektiert und, teilweise durch die Zwischenlage transmittiert, an einer weiteren Grenzfläche wiederum reflektiert wird. Die Zwischenlage umfasst dabei üblicherweise mindestens zwei Schichten, eine, die optisch wirksam ist, insbesondere mindestens die eine Reflexion mitbestimmt, die andere, die als Abstandhalteschicht wirkt.

An einen derartigen Informationsträger wird die Forderung gestellt, dass die Information von beiden Grenzflächen im wesentlichen gleichermassen auslesbar sein soll.

Aus der EP-A-0 388 852 ist ein magnetooptischer Informationsträger bekannt mit einer magnetooptischen Speicherschicht und mindestens einer Schutzschicht hierfür. Es wird ausgeführt, die Dicke dieser Schutzschicht, aus Si, N und H, sei nicht speziell kritisch, doch solle deren Brechungsindex mindestens 1,9 sein. Sei die Schutzschicht zwischen dem Substrat und einer magnetischen Schicht eingebaut, habe erstere eine Dicke zwischen 50 nm und 150 nm, um den Kerr-Effekt zu verstärken. Werde die Schutzschicht als rücklagige Schutzschicht eingesetzt, solle deren Dicke 30 bis 200 nm betragen.

Aus der EP-A-0 592 174 ist ein Verfahren zur Herstellung magnetooptischer Speichermedien bekannt mit einem Speicherschichtsystem, welches eine dielektrische Schicht, eine optomagnetische Speicherschicht und weitere dielektrische Schichten umfasst sowie mit einer Lackschutzschicht auf dem Speicherschichtsystem. Der Einsatz von Siliziumtargets mit verschiedenen Kristallorientierungen ist für die reaktive Abscheidung der dielektrischen Schichten diskutiert, so aus SiN, SiO, SiC bei Schichtdicken von 100 bis 1500 Å bzw. 100 bis 1000 Å, abhängig von der Lage der betrachteten dielektrischen Schicht bezüglich der optomagnetischen Speicherschicht.

Aus der EP-A-658 885 ist ein optischer Informationsträger mit mehreren Datenflächen bekannt. An Substratoberflächen sind Datenflächen vorgesehen. Sie sind mit einer dünnen Schicht eines Halbleitermaterials, wie aus amorphem Silizium, beschichtet. Die Dicke dieser Schichten ist so, dass optische Detektoren von jeder der Datenflächen dieselbe Lichtmenge erhalten. Hierzu sollen sie einen Brechungsindex haben, der relativ hoch ist und einen Extinktionskoeffizienten, der relativ tief ist. Durch Anpassung ihrer jeweiligen Dicken wird die jeweils an einer Schicht erwünschte Reflexion, Transmission und Absorption eingestellt. Für Licht im Bereich von 400 - 850 nm wird als Schichtmaterial amorphes Silizium eingesetzt. Unter anderem für dieses Schichtmaterial sind auch Schichtdicken angegeben.

Aus der US-A-5 414 678 ist ein magnetooptischer Informationsträger bekannt mit zwei Aufnahmeschichten. Die Aufnahmeschichten sind zwischen dielektrischen eingebettet, so aus SiN, SiC, SiO, YO, AlN, SiAlON. Die Dicke der dielektrischen Schichten wird mit 10 bis 150 nm angegeben.

Aus der EP-A-0 729 142 ist ein optischer Informationsträger bekannt. Zwei beabstandete Festkörper-Grenzflächen sind mit einem informationsbeinhaltenden Muster von Einkerbungen versehen. Die eine Fläche wirkt reflektierend und ist hierfür beispielsweise alminiumbeschichtet, während die andere Fläche halbdurchlässig ausgebildet ist. Die Halbdurchlässigkeit wird mittels einer Schicht aus SiN, $SiO_2$ oder ähnlichem erwirkt, abgelegt mit einer Dicke von 15 nm. Sie liegt zwischen den Festkörper-Grenzflächen, gemeinsam mit einer Schicht UV-härtbaren Lackes.

Schliesslich ist aus der EP-A-368 442 ein Informationsträger eingangs genannter Art bekannt, bei welchem die Rexlexionsverhältnisse an den Festkörper-Grenzflächen mittels $\lambda/4$-Schichten vorgegeben werden, wobei $\lambda$ die Wellenlänge des Lichtes ist, mittels welchem Information vom Träger ausgelesen wird.

Es ist Aufgabe der vorliegenden Erfindung, einen Informationsträger eingangs genannter Art vorzuschlagen, welcher einfach und wirtschaftlich herstellbar ist. Dies wird durch den Informationsträger gelöst, welcher sich nach dem Kennzeichen von Anspruch 1 auszeichnet bzw. durch ein Verfahren zur Herstellung eines solchen Informationsträgers, nach dem Kennzeichen von Anspruch 25 ausgeführt.

Dabei wurde erkannt, dass die Reflexion an einer der Festkörper-Grenzflächen wenig kritisch von der optischen Dicke des dielektrischen Schichtsystems abhängt. Damit kann die geometrische Dicke des betrachteten dielektrischen Schichtsystems wesentlich geringer gewählt werden als entsprechend einem ganzzahligen Wert von m, wobei die Reflexion nur unwesentlich reduziert wird, die Transmission aber wesentlich erhöht wird.

Die Möglichkeit, die Schicht mit reduzierter Dicke vorzusehen, führt zu einer wesentlichen Verbesserung wirtschaftlicher Produktion (durch Erhöhung des Ausstosses).

Die Tatsache, dass generell die Reflexion unkritisch ist, bezüglich der geometrischen Schichtdicke, reduziert weiter wesentlich die Aufwendungen, welche für eine Dickenbeherrschung bei der Schichtherstellung zu treiben sind.

Es sollen weiter mindestens einer der nachfolgenden Vorteile vorzugsweise erwirkt werden:

- Die Reflexion an einer der Zwischenlagenoberflächen und einem Anschlussmedium, welche gemeinsam die Grenzfläche bilden, soll so hoch wie möglich sein. Gleichzeitig soll aber auch die Transmission durch die Zwischenlage, für Strahlung der gegebenen Wellenlänge, maximal werden, d.h. die Absorption vernachlässigbar. Das Anschlussmedium ist üblicherweise das Trägersubstratmaterial oder das Abstandhalteschichtmaterial oder ein Deckschichtmaterial.

- Das dielektrische Schichtsystem soll bei derart tiefen Temperaturen aufbringbar sein, dass es auf üblicherweise als Substratmaterial eingesetzte Kunststoffe aufbringbar ist.

- Es soll auch im UV-Spektralbereich eine hohe Transmission aufweisen, derart, dass gegebenenfalls eingesetzte UVhärtbare Lacke, als Anschlussmedium bzw. Material einer Abstandhalteschicht, durch die optisch wirksame Schicht hindurch, mittels UV-Strahlung ausgehärtet werden können.

- Es soll auf üblichen Kunststoffsubstratmaterialien sowie üblicherweise vorgesehenen Grenzschichtanschlussmedia, wie den erwähnten Lacken, gut haften.

- Es soll sich insbesondere für den Einsatz elektromagnetischer Strahlung im Wellenlängenbereich von 400nm bis 800nm, aber insbesondere zwischen 633nm und 650nm eignen.

Diese weiteren Aufgabe werden dadurch gelöst, dass die mindestens eine Schicht mindestens überwiegend aus $Si_xC_y$ oder $Si_vN_w$ besteht.

Als dielektrische Schichtmaterialien kommen nebst den erwähnten, primär bevorzugten Materialien $Si_xC_y$ bzw. $Si_xC_yH_z$, $Si_vN_w$ bzw. $Si_vN_wH_u$ auch ZrN oder gar auch HfN sowie TiN in Frage.

Wenn $Si_xC_y$, $Si_xC_yH_z$, $Si_vN_w$ oder $Si_vN_wH_u$ als Schichtmaterial eingesetzt wird, sollte x/y und entsprechend v/w > 1 sein, dabei bevorzugterweise $x/y \geq 1,2$ und entsprechend $v/w \geq 1,2$ und, gar besser, $x/y \geq 2$ bzw. $v/w \geq 1,6$.

Dabei erlaubt die erwähnte Schicht an der Zwischenlage, dank ihrer reflexionsbestimmenden Eigenschaften (Brechungswert n) sowie ihren Transmissions-Eigenschaften (tiefe Absorption), drei bzw. mehr als drei informationsbeaufschlagte oder - beaufschlagbare Grenzschichten an einem Informationsträger zu realisieren und auch daran die Information von einer Trägerseite her auszulesen, bevorzugt mit Strahlung einer Wellenlänge.

Verfahrensmässig wird bevorzugt, bei der Herstellung mindestens einer mindestens im wesentlichen aus $Si_xC_yH_z$ oder $Si_vN_wH_u$ bestehenden Schicht durch einen reaktiven Vakuumbeschichtungsprozess, dass Silicium von einem Festkörper in die Prozessatmosphäre freigesetzt und in der Prozessatmosphäre mit einem Reaktivgas zur Reaktion gebracht wird, welches C und/oder N enthält, vorzugsweise entweder C oder N.

Im weiteren wird bevorzugt, die mindestens eine Schicht, welche mindestens im wesentlichen aus $Si_xC_yH_z$ oder aus $Si_vN_wH_u$ besteht, durch einen reaktiven Vakuumbeschichtungsprozess zu erzeugen, worin ein Optimum der Transmission der Schicht und des Brechungswertes des Schichtmaterials durch Einstellung der Konzentration eines Gases in der Prozessatmosphäre erreicht wird, welches Gas mindestens zwei der Komponenten C, N, H enthält, vorzugsweise C und H oder N und H.

Weitere Vorteile werden durch bevorzugte Ausführungsformen der Erfindung erwirkt, wie sie in den Ansprüchen und, beispielsweise, in der nachfolgenden Beschreibung mit Figuren und Beispielen erläutert sind.

Es zeigen:

Fig. 1    schematisch eine Zwischenlage an einem Informationsträger unter seinem weitesten Aspekt;

Fig. 2    schematisch einen Ausschnitt aus einem optischen Informationsträger mit zwei Informationsgrenzflächen;

Fig. 3    in Darstellung analog zu Fig. 2 einen Ausschnitt aus einem Informationsträger mit drei Informationsgrenzflächen;

Fig. 4    schematisch eine Anlagenkonfiguration zur Schichtherstellung und zur Durchführung eines erfindungsgemässen Herstellungsprozesses;

Fig. 5    schematisch eine Konfiguration einer weiteren, bevorzugten Anlage zur Durchführung des erfindungsgemässen Prozesses, mit bevorzugtem Target.

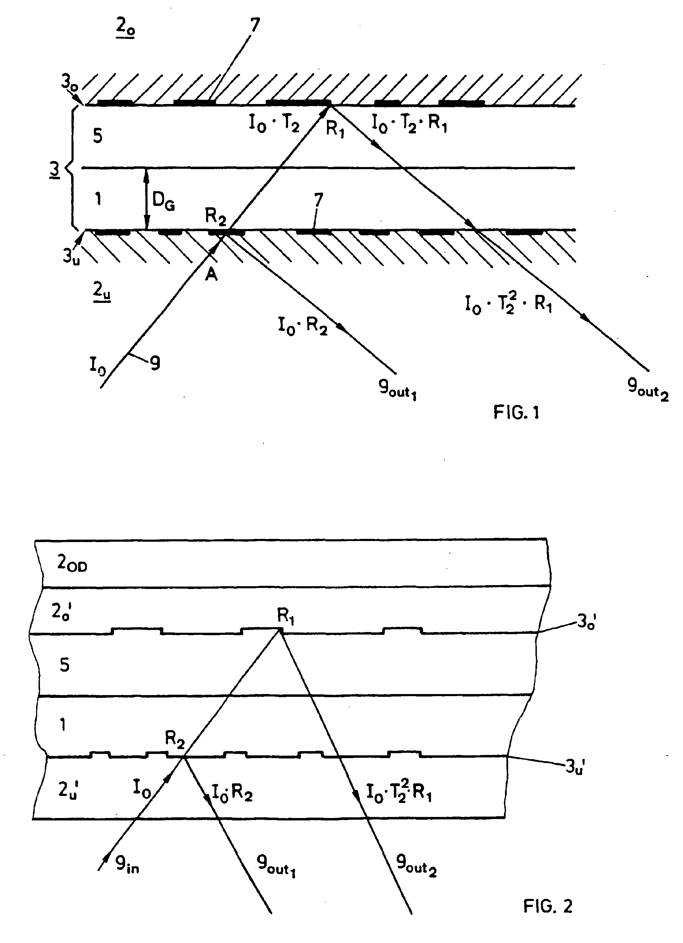

In Fig. 1 ist, prinzipiell, ein Ausschnitt aus einem einseitig doppelt oder mehrfach reflektierenden Informationsträger dargestellt. Eine Zwischenlage 3 ist eingebettet zwischen Anschlussmedia $2_o$ und $2_u$. Die Zwischenlage 3 umfasst eine dielektrische Schicht 1 sowie eine Abstandhalteschicht 5. Letztere besteht vorzugsweise aus einem Lack, insbesondere einem UV-härtbaren, wie z.B. einem 2P-Lack der Fa. Philips.

Die dielektrische Schicht 1 besteht mit erster Vorzugspriorität mindestens im wesentlichen aus $Si_xC_yH_z$ und/oder $Si_vN_wH_u$, dabei vorzugsweise aus einem dieser Materialien, in zweiter aus $Si_xC_y$ und/oder $Si_vN_w$ oder in dritter aus ZrN oder mindestens im wesentlichen aus HfN oder TiN. Unter dritter Priorität wird ZrN bevorzugt.

Dabei ist "bestehen" so zu verstehen, dass durchaus noch weitere Komponenten im Schichtmaterial vorhanden sein können, aber mit einem untergeordneten Anteil.

Es bilden Medium $2_u$ und Schicht 1 die eine Grenzfläche $3_u$, Medium $2_o$ und Abstandhalteschicht 5 die zweite $3_o$. An diesen zwei Grenzflächen ist eine informative Struktur aufgebracht bzw. einbringbar, durch örtliche Modulation von Oberflächeneigenschaften, z.B. für optische Informationsträger der geometrischen Struktur oder für magnetooptische Träger der magnetischen Eigenschaften.

Die informative Struktur ist in Fig. 1 prinzipiell durch die Bereiche 7 dargestellt. Die modulierte Festkörpereigenschaft, d.h., wie erwähnt, beispielsweise geometrische Oberflächenstrukturierung oder magnetische Oberflächenstrukturierung, moduliert einfallende elektromagnetische Strahlung 9 bei deren Relativverschieb entlang der Grenzflächen $3_o$, $3_u$, wie dies dem Fachmann hinlänglich bekannt ist.

Die elektromagnetische Strahlung 9 mit einer Intensität $I_o$ wird einerseits an der einen Grenzfläche $3_u$ reflektiert, entsprechend einem reflektierten Anteil $I_o \cdot R_2$, worin $R_2$ den Reflexionsfaktor angibt. Anderseits wird der Teil $I_o \cdot (1-R_2-A_2) = I_o \cdot T_2$ durch die Zwischenlage 3 transmittiert, wobei $A_2$ die Absorption in der Zwischenlage und $T_2$ die Transmission durch die Zwischenlage bedeuten. Dieser Anteil $I_o \cdot T_2$ geht praktisch verlustlos durch die Abstandhalteschicht 5 hindurch und wird, entsprechend dem Faktor $R_1$, entsprechend dem Anteil $I_o \cdot R_1 \cdot T_2$ reflektiert. Nach Durchlaufen der Abstandhalteschicht 5 und der Schicht 1 ergibt sich die Strahlung zu $I_1 = I_o \cdot T_2^2 \cdot R_1$. Dabei muss darauf hingewiesen werden, dass die Transmission $T_2$ als quadratischen Term $T_2^2$ in den Ausdruck für $I_1$ eingeht.

Die Energieaufteilungen, wie sie anhand von Fig. 1 gezeigt und erläutert sind, sind Näherungen, bei welchen der vernachlässigbare Einfluss der optisch inaktiven Abstandhalteschicht 5 nicht berücksichtigt ist. Bezüglich komplexerer Näherungen höherer Ordnungen dieser Energiebetrachtungen wird auf "Optical Recording", Alan B. Marchant, Addison-Wesley, 1990, Publishing Company, chapter 13, S. 344 bis 353, verwiesen. Die genauen Verteilungen können mit Hilfe des Programmes "Film*STAR", Optical Thin Film Software, FTG Software Associates, P.O. Box 579, Princeton, N.J. 08542, berechnet werden.

Gefordert wird eine möglichst gleiche Energie an den reflektierten Strahlen $9_{out1,2}$.

Es ist bekannt, an der Zwischenlage 3 eine metallische Schicht oder metallähnliche Schicht, wie aus Au, vorzusehen, woran aber, nebst der Transmission $T_2$, auch die Reflexion sehr empfindlich mit der geometrischen Dicke $D_G$ variiert und die teuer in der Herstellung ist.

Wie erwähnt, besteht die erfindungsgemäss eingesetzte Schicht 1 weit bevorzugterweise mindestens überwiegend aus $Si_xC_y$, $Si_xC_yH_y$, $Si_vN_w$ oder $Si_vN_wH_u$. Die Schicht 1 besteht dabei weiter bevorzugterweise mindestens überwiegend aus einem der erwähnten Materialien, wobei sie aber auch aus mindestens zwei dieser erwähnten vier Materialien mindestens überwiegend bestehen kann.

Die folgenden bevorzugten Werte und Verhältnisse für x, y, z und v, w, u wurden ermittelt:

1. Es wird weitaus bevorzugt, dass

1.1 $x \geq y$ und entsprechend $v \geq w$, unabhängig von z und u.

1.1.1 Dabei wird weiter bevorzugt, dass
$x \geq 1,2y$ und entsprechend $v \geq 1,2w$
und gar mehr, dass
$x \geq 2y$ und entsprechend $v \geq 1,6w$, unabhängig von z und u.

Dies ist gültig für Materialien, welche überwiegend aus einem der vier erwähnten Materialien bestehen, würde aber auch gültig sein für Materialien, welche, zu überwiegendem Anteil, aus zwei, drei oder vier der erwähnten Materialien zusammengesetzt sind.

Es wird weiter bevorzugt:

2. $x \leq 0,8$; $y \geq 0,05$ und $z \geq 0,1$,
dabei insbesondere
$x \leq 0,52$; $y \geq 0,1$ und $z \geq 0,2$,
$v \leq 0,8$; $w \geq 0,05$, bevorzugterweise $w \geq 0,1$.

3. Die folgenden Verhältnisse sind besonders vorteilhaft:

3.1 $[0,445 : 0,262] \leq [x : y] \leq [0,775 : 0,078]$,
unabhängig vom Wert von z und unabhängig davon, ob die Schicht im wesentlichen aus einer Einzelkomponente oder aus einem Mehrkomponentenmaterial besteht.

3.2 $[0,445 : 0,249] \leq [x : z] \leq [0,775 : 0,118]$,
unabhängig vom Wert von y und unabhängig davon, ob das Schichtmaterial mindestens überwiegend aus einer Komponente oder aus mehreren Komponenten der obgenannten Art besteht.

3.3 $[0,078 : 0,249] \leq [y : z] \leq [0,262 : 0,118]$,
unabhängig vom Wert von x und unabhängig davon, ob das Schichtmaterial mindestens überwiegend aus einer Komponente oder aus mehreren Komponenten besteht.

3.4 Tatsächlich wurde gefunden, dass der höchste Reflexionskoeffizient des Materials $Si_xC_yH_z$ dann erreicht wird, wenn

$$x:y:z = 0,704\ (\pm10\%):0,087\ (\pm10\%):0,131\ (\pm10\%)$$

realisiert wird, wobei $\pm$ 10% die Messgenauigkeit und somit die statistische Verteilung bei mehreren Messungen anzeigen.
Für den tiefsten Brechungswert, der immer noch einsetzbar ist, wurde gefunden:

$$x:y:z = 0,494\ (\pm10\%):0,238\ (\pm10\%):0,226\ (\pm10\%).$$

3.5 $[0,527 : 0,401] \leq [v : w] \leq [0,858 : 0,099]$,
unabhängig vom Wert von u und unabhängig davon, ob das Material mindestens überwiegend aus einer Komponente oder aus mehreren Komponenten besteht.

3.6 $[0,527 : 0,044] \leq [v : u] \leq [0,858 : 0,009]$,
unabhängig vom Wert von w und unabhängig davon, ob das Schichtmaterial mindestens überwiegend aus einer Komponente oder aus mehreren Komponenten besteht.

3.7 $[0,099 : 0,044] \leq [w : u] \leq [0,401 : 0,009]$,
unabhängig vom Wert von v und unabhängig davon, ob das Schichtmaterial mindestens überwiegend aus einer Komponente oder aus mehreren Komponenten besteht.

3.8 Tatsächlich wurde weiter gefunden, dass der höchste Brechungswert des Materials $Si_vN_w$ dann erreicht wird, wenn

$$v : w = 0,78 \ (\pm 10\%) : 0,11 \ (\pm 10\%),$$

unabhängig vom Wert von u. Die $\pm$ 10% zeigen die statistische Verteilung bei einer Vielzahl von Messungen an. Für den tiefsten Brechungswert, welcher jedoch noch einsetzbar ist, gilt:

$$v : w = 0,586 \ (\pm 10\%) : 0,364 \ (\pm 10\%),$$

unabhängig vom Wert von u.

Dies gilt insbesondere, wenn als elektromagnetische Strahlung 9 Licht mit einer Wellenlänge $\lambda_s$ eingesetzt wird, für welche gilt:

$$400nm \leq \lambda_s \leq 800nm,$$

und insbesondere gilt:

$$630nm \leq \lambda_s \leq 655nm.$$

Im Gegensatz zum bekannten Einsatz von metallischen Schichten für den Aufbau der Schicht 1 wird nun an der erfindungsgemäss vorgesehenen Schicht 1, vorzugsweise aus $Si_xC_y$ und/oder $Si_vN_w$ oder, gar mehr bevorzugt, aus $Si_xC_yH_z$ und/oder $Si_vN_wH_u$, Interferenz ausgenützt, indem für die optische Dicke D der Schicht 1 gilt:

$$D = m \cdot \lambda_o/4,$$

worin $m \geq 1$ ganzzahlig und ungerade ist, jedoch durch bis zu 0,6 reduziert werden kann oder durch bis zu 0,2. $\lambda_o$ ist die optische Wellenlänge der Strahlung 9 im Zwischenlagenmaterial, d.h. insbesondere im Material der Schicht 1.
Dabei wird die Reflexion $R_2$ wesentlich weniger kritisch von der geometrischen Dicke

$$D_G = (m/n) \cdot (\lambda_o/4)$$
$$(n: \ Brechungswert)$$

abhängig, weil die optische Dicke

$$D = m \cdot \lambda_O / 4$$

entsprechend der Reduktion von m um einen Wert bis zu 0,6 variieren kann oder um einen Wert bis zu 0,2 vergrössert werden kann.

Damit kann $D_G$ wesentlich geringer gewählt werden (Dicke der Schicht!) als entsprechend einem ganzzahligen Wert von m, wobei

- die Reflexion nur unwesentlich reduziert wird,
- die Transmission wesentlich erhöht wird.

Die Möglichkeit, die Schicht mit reduzierter Dicke ($D_G$) vorzusehen, führt weiter zu einer wesentlichen Verbesserung wirtschaftlicher Produktion (durch Erhöhung des Ausstosses).

Die Tatsache, dass generell die Reflexion unkritisch ist bezüglich $D_G$, reduziert weiter wesentlich die Aufwendungen, welche für eine Dickenbeherrschung bei der Schichtherstellung zu treiben sind.

Weil die Transmission $T_2$ quadratisch im Ausdruck für den Strahl $9_{out2}$ (s. Fig. 1) auftritt, bewirkt eine Erhöhung von $T_2$ eine wesentliche Verbesserung der Energieverteilung an den Strahlen $9_{out1}$ und $9_{out2}$ zu einer Gleichverteilung hin. Wie erwähnt wurde, erscheint die Transmission $T_2$ quadratisch im Energieausdruck für den Strahl $9_{out2}$. Damit ergibt bereits eine geringe Reduktion der geometrischen Dicke der Schicht eine wesentliche Verbesserung an diesem erwähnten Strahl.

Im weiteren wirkt die Reflexionsverteilung entlang der Grenzfläche $3_o$ wesentlich weniger empfindlich auf Dickenschwankungen entsprechend $D_G$ der Schicht 1 auf der Materialphase $2_u$, was wiederum zu einem wesentlichen Vorteil in der Herstellung der Schicht 1 führt.

Die Abstandhalteschicht 5 wird, insbesondere bei optischen Informationsträgern, vorzugsweise durch einen strukturierbaren Lack, wie beispielsweise einen Lack "2P" der Firma Philips, realisiert, also mittels Laken, die UV ($\lambda_s <$ 400nm) -gehärtet werden.

Hierfür sichert die erfindungsgemäss aufgebaute Schicht 1 an sich bereits eine hohe Transmission (tiefe Absorption) im UV-Bereich, welche aber durch die erwähnte Möglichkeit, ohne Reflexionseinbusse die Schichtdicke $D_G$ zu verringern, noch wesentlich erhöht wird. So wird eine Transmission für Strahlung im UV-Bereich erreicht, die mindestens 10% beträgt. Die Zwischenlage 3, insbesondere bei optischen Informationsträgern, wird üblicherweise auf einem Kunststoff, insbesondere auf strukturiertem Polycarbonat oder PMMA, als Anschlussmedium $2_u$ abgelegt.

Ein wesentlicher Vorteil der bevorzugten Schicht 1 ist nun auch darin zu erblicken, dass sowohl im weitaus bevorzugten Schichtmaterial $Si_xC_y$ bzw. $Si_xC_yH_z$ wie auch im erwähnten Kunststoffsubstratmaterial und den erwähnten Laken Kohlenstoff enthalten ist, so dass eine starke Bindung und damit Haftung des Schichtmaterials mit bzw. an die erwähnten Anschlussmedien resultiert.

Um eine Reflexion $R_2$ von 30 $\pm$ 10% zwischen üblichen Substratkunststoffen, wie Polycarbonat oder PMMA, und dem Material der Schicht 1 zu erreichen, ist am Schichtmaterial ein sehr hoher Brechwert $n_1$ erforderlich, weil nämlich der Brechwert des erwähnten Substratmaterials bereits hoch ist, für Polycarbonat beispielsweise ca. 1.57 beträgt. Wenn anderseits bei den eingesetzten Schichtmaterialien der Brechwert $n_1$ erhöht wird, führt dies zu einem Absenken der Transmission $T_2$, d.h. zu einer Zunahme der Absorption im Material der Schicht 1. Das von der Grenzfläche $3_o$ gemäss Fig. 1 gewonnene Signal ist aber sehr empfindlich von einer Abnahme der Transmission $T_2$ (Zunahme der Absorption) abhängig. Durch Einstellung des Stöchiometrieverhältnisses x/y und insbesondere x/y/z, wie oben angegeben, gelingt es, einen optimalen Kompromiss der sich zuwiderlaufenden Anforderungen an Brechwert und Transmission einzustellen. Insbesondere beim bevorzugten Schichtmaterial $Si_xC_yH_z$ kann dabei durch Variation von zwei Parametern, nämlich des Kohlenstoffanteils y und des Wasserstoffanteils z, den erwähnten sich zuwiderlaufenden Anforderungen optimal Rechnung getragen werden. Wie dies herstellungstechnisch erreicht wird, soll später anhand des Herstellungsverfahrens ausgeführt werden.

Mit Einsatz der bevorzugten Schicht 1 aus $Si_xC_y$, $Si_xC_yH_z$, $Si_vN_w$ oder $Si_vN_wH_u$ wurde es möglich, Reflexionswerte $R_2$ (635nm) an Polycarbonat als Phase $2_u$ von 20% bis 40% zu erreichen. Dies führte zu einer in der Zwischenlage 3 transmittierten Energie von 60% bis 80%, die auf die zweite Grenzfläche $3_o$ auftrifft, die Absorption $A_2$ bei der erwähnten Wellenlänge $\lambda_s$ von praktisch 0% berücksichtigend. Die Reflexion $R_1$ wird durch Wahl des Mediums $2_o$ gemäss Fig. 1 optimiert und betrug z.B. für Al als Material der Phase $2_o$ 81% der auf die zweite Grenzfläche auftreffenden Energie. Damit resultierte, entsprechend Fig. 1, für einen Strahl $9_{out1}$ von 20% ein Strahl $9_{out2}$ von 52% und für einen Strahl $9_{out1}$ von 40% ein Strahl $9_{out2}$ von 29% der einfallenden Energie.

Mit hoher Wahrscheinlichkeit können die erfindungsgemässen Zwischenlagen 3 bzw. Schichten 1 auch für Strahlung im blauen Bereich, d.h. mit Wellenlängen 400nm ≤ $\lambda_s$ ≤ 500nm, erfolgreich eingesetzt werden. Im weiteren kann die erfindungsgemäss ausgebildete Schicht im Sinne der hybriden MMCD, wie sie oben beschrieben wurden, dazu eingesetzt werden, Strahlung mit selektiv unterschiedlichen Wellenlängen einzusetzen, wie beispielsweise von 635nm und 785nm, um selektiv Information an der einen Grenzfläche mit Strahlung der einen Wellenlänge und von der zweiten Grenzfläche durch Strahlung der zweiten Wellenlänge auszulesen. Wenn dabei, mit Blick auf Fig. 1, z.B. Strahlung der Wellenlänge 635nm eingesetzt wird, um Information von der Grenzfläche $3_u$ auszulesen und Strahlung mit einer Wellenlänge von 785nm dafür, Information von der Grenzfläche $3_o$ auszulesen, dann wird die optisch wirksame Schicht 1 so ausgelegt, dass praktisch die gesamte Energie bei 635nm an $R_2$ reflektiert wird und praktisch die gesamte Energie bei 785nm auf die Grenzfläche $3_o$ transmittiert wird und dort reflektiert wird. Dies wird durch Auslegung der geometrischen Dicke $D_G$ der Schicht 1 realisiert, so dass sie auf der Basis einer ungeraden Anzahl von Viertelwellenlängen entsprechend 635nm ausgelegt wird, gleichzeitig aber auf der Basis einer geraden Anzahl Viertelwellenlängen bei 785nm.

Wie vorgängig erwähnt wurde, gilt für eine ungerade Zahl Viertelwellenlängen für m:

$$0,4 \leq m \leq 1,2; \quad\quad 2,4 \leq m \leq 3,2;$$
$$\text{(erster Ordnung)} \quad\quad \text{(dritter Ordnung)}$$
$$4,4 \leq m \leq 5,2; \quad\quad .....$$
$$\text{(fünfter Ordnung)}$$

Bezüglich Polycarbonat und höchst wahrscheinlich bezüglich PMMA einerseits wie auch höchstwahrscheinlich bezüglich UVhärtbarer Lacke erfüllt die Schicht 1 mit Bezug auf Haftung die Haftungs-tape-tests entsprechend MIL-M-13508C und/oder MIL-C-00675B, wie sie in H. Pulker, "Coatings on Glass", S. 358, Elsevier, 1984, definiert sind.

In Fig. 2 ist ein bevorzugtes Ausführungsbeispiel eines optischen Informationsträgers dargestellt, ausgebildet als optische Speicherplatte mit zwei Informationsgrenzflächen $3_o'$, $3_u'$.

Auf einem Substratträger $2_u'$, vorzugsweise aus Polycarbonat oder PMMA, ist eine Schicht 1 abgelegt, entsprechend den bevorzugten Angaben unter 1) bis 3.8).

Auf der Abstandhalteschicht 5 ist eine metallische Reflexionsschicht $2_o'$ aus Au oder Ag, vorzugsweise aber aus Al vorgesehen. Die hochreflektierende Schicht $2_o'$ ist mit einer Deckschicht $2_{oD}$ abgedeckt.

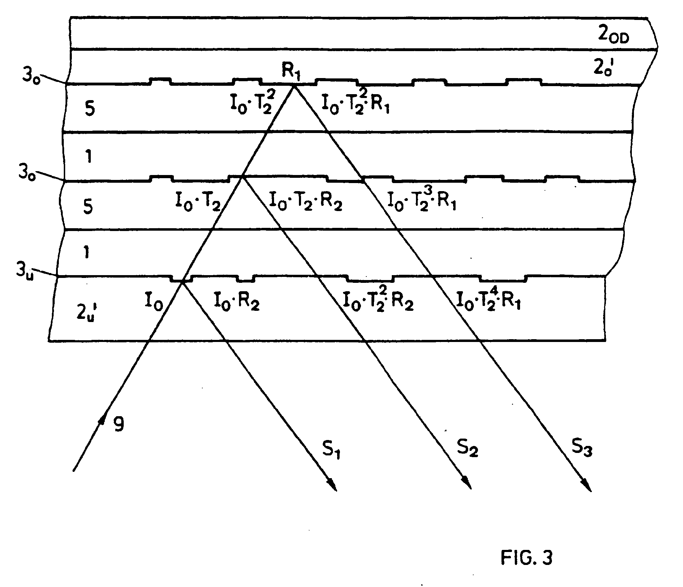

Bei der weiteren Ausführungsvariante gemäss Fig. 3 sind folgende Schichten vorgesehen:

- Trägersubstrat $2_u'$, vorzugsweise aus Polycarbonat oder PMMA;

- Schicht 1 vorzugsweise aus den obgenannten Materialien, nämlich $Si_xC_yH_z$, $Si_xC_y$, $Si_vN_wH_u$ oder $Si_vN_w$;

- Abstandhalteschicht 5 vorzugsweise aus UV-härtbarem Lack, vorzugsweise "2P" Lack, welcher die zweite Grenzfläche $3_{o1}$ zu einer weiteren Schicht definiert, vorzugsweise aus $Si_xC_yH_z$, $Si_xC_y$, $Si_vN_wH_u$ oder $Si_vN_w$;

- eine Abstandhalteschicht 5 vorzugsweise aus UV-härtbarem Lack, die die dritte Grenzfläche $3_{o2}$ zu einer hochreflektierenden Metall-, insbesondere Al-Schicht $2_o'$ definiert.

Von jeder der drei Grenzflächen $3_u$, $3_{o1}$, $3_{o2}$ wird, vorzugsweise wiederum bei einer Laserlichtwellenlänge von 635nm, gerade soviel reflektiert, dass die Auslesestrahlen $S_1$ bis $S_3$ ca. je 20% der einfallenden Energie I enthalten. Die Absorption je "halbdurchlässige" Schicht 1 ist kleiner als 2% und entsprechend hoch ist die jeweilige $T_2$.

Die Ausführungsvariante gemäss Fig. 3, angewendet auf die vorerwähnte MMCD-Technik, ergibt eine Speicherkapazität pro einseitig bespielter 120mm-Durchmesser-CD von ca. 11GByte, während sich damit bei einer SD (Super Density Disk) eine Speicherkapazität pro CD-Seite von ca. 13GByte und für eine doppelseitige SD von ca. 27GByte ergibt.

Anschliessend soll anhand von Anlagenkonfigurationen das erfindungsgemässe Verfahren erläutert werden, welches sich nicht ausschliesslich, aber insbesondere für die Herstellung der "halbdurchlässigen" Schicht 1 an den erfindungsgemässen Informationsträgern, wie vorerläutert, eignet.

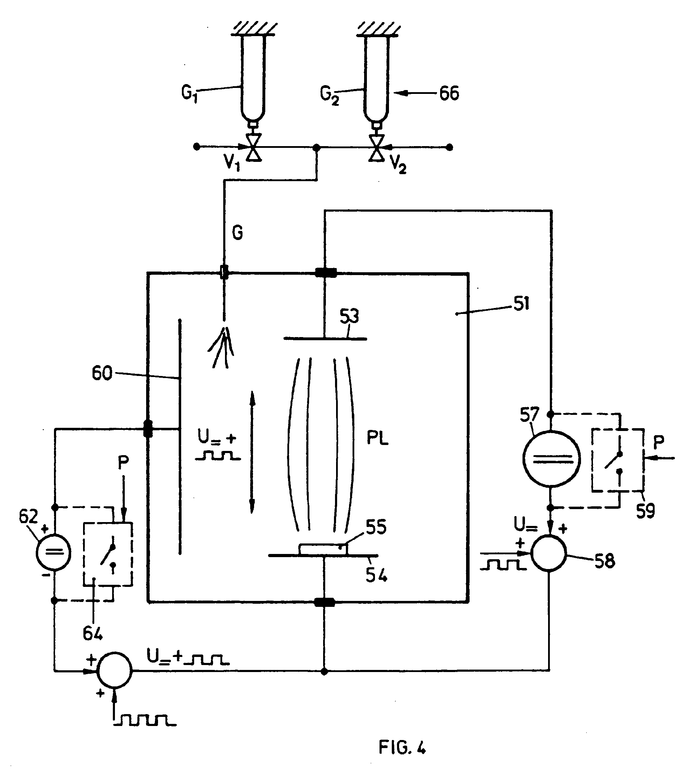

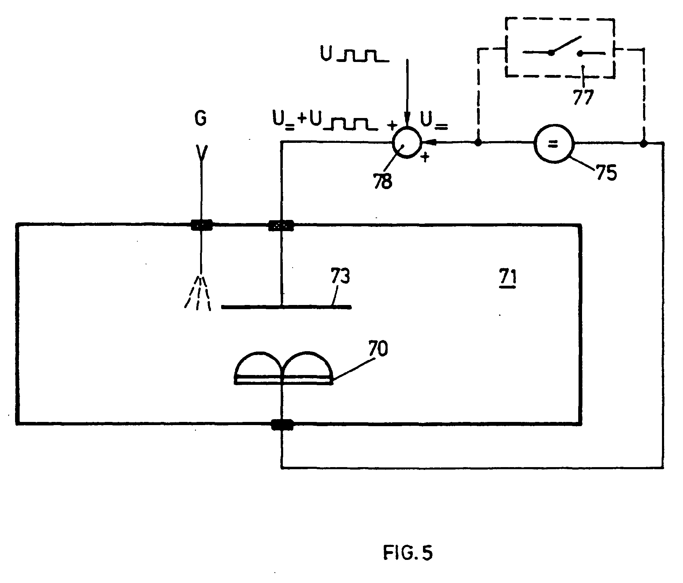

An der schematisch dargestellten Anlage von Fig. 4 wird die "halbdurchlässige" Schicht 1 (Fig. 1 bis 3) durch Ionenplattieren abgelegt, während bei der bevorzugten Anlagenkonfiguration gemäss Fig. 5, in bevorzugter Art und Weise, die abgelegte Schicht 1 durch reaktives Sputterbeschichten abgelegt wird.

Bei den erfindungsgemässen Herstellungsverfahren - es dürfte ohne weiteres möglich sein, die angeführten Schichten an den erfindungsgemässen Informationsträgern auch auf andere Art und Weise herzustellen - wird einerseits, als erster wichtiger Aspekt, das Verhältnis von Transmission $T_2$ und Brechwert $n_1$ an der bevorzugt eingesetzten $Si_xC_yH_z$- und/oder $Si_vN_wH_u$-Schicht durch Führung des Verhältnisses von Kohlenstoff zu Wasserstoff optimiert. Dies vorzugsweise durch gesteuerte bzw. geregelte Zuführung mindestens zweier Gase mit unterschiedlichen C/H- oder N/H-Anteilen in die Prozessatmosphäre. Als zweiter wichtiger Aspekt, alternativ oder additiv zum ersten, werden von hochreinem Silicium als Festkörper Si-Atome in die Prozessatmosphäre freigesetzt und dort mit kohlenstoff-, bevorzugterweise kohlenstoff- und wasserstoffhaltigem Gas zur Reaktion gebracht. Der erste Aspekt erlaubt, durch Führung der Anteile der erwähnten Gase in der Prozessatmosphäre, die optischen Verhältnisse zu optimieren, der zweite, einen kostengünstigen, gut beherrschbaren Prozess einzusetzen.

Als Prozessgas wird vorzugsweise ein Edelgas, z.B. Ar, verwendet.

Als Reaktivgase werden Kohlenwasserstoffgase eingesetzt, wie z.B. Butan $C_4H_{10}$, Methan $CH_4$, Propan $C_3H_8$, Stickstoff $N_2$ oder Stickstoff-Wasserstoffgase, wobei durch Steuerung oder Regelung der Gasflüsse in die Prozessatmosphäre mehr oder weniger Kohlenstoff C oder Stickstoff N pro Zeiteinheit in die Prozessatmosphäre eingelassen werden, bezogen auf den Wasserstoff, welcher pro Zeiteinheit eingelassen wird.

Das Freisetzen von Si von einer Si-Festkörperquelle führt zu wesentlich kostengünstigeren Festkörperquellen als beispielsweise das Freisetzen von SiC aus bekannten Graphit-dotierten Silicium-Quellen. Durch die exakt festgelegte Festkörperzusammensetzung des Siliciums an der Festkörperquelle wird der gesamte Beschichtungsprozess besser kontrollierbar und, durch Variation der Prozessgaszusammensetzung, führbar.

Gemäss Fig. 4, welche, schematisch, eine Ionenplattieranlage zeigt, wird in einer Vakuumkammer 51, zwischen Elektrode 53 und 54, eine Plasmaentladung PL betrieben. Mit der Entladung PL wird Silicium eines Targets 55, wie dargestellt an der Elektrode 54, in die Prozessatmosphäre verdampft oder zerstäubt. Anstelle (nicht eingezeichnet) einer Entladung PL kann selbstverständlich, und wie dem Fachmann bekannt, das Silicium mittels thermischer Verdampfung, wie z.B. mittels Elektronenstrahlverdampfens, in die Prozessatmosphäre freigesetzt werden.

Die Entladung PL kann betrieben werden:

- mit Hochfrequenz Hf

- mit DC

- mit DC+Hf

- mit DC+Mittelfrequenz

- mit DC+Tieffrequenz
  dabei vorzugsweise mit DC und überlagertem Mittelfrequenz- oder Tieffrequenz-Impulssignal.

Dabei ist aber zu beachten, dass das in der Prozessatmosphäre erzeugte Schichtmaterial ebenso wie das Silicium elektrisch schlecht leiten, so dass der Prozessbeherrschung, mit Blick auf Funkenbildung und Quellenvergiftung, hohe Beachtung zu schenken ist.

In der dargestellten, weitaus bevorzugten Realisationsform wird die Entladung PL mittels einer DC-Quelle 57 betrieben. Die Stabilität des Beschichtungsprozesses wird aber trotz des Einsatzes der kostengünstigen DC-Quelle 57 dadurch sichergestellt, dass signaltechnisch der DC-Ausgangsspannung $U_=$ der Quelle 57 im Mittel- oder Tieffrequenzbereich eine vorzugsweise Impulsspannung überlagert wird, wie dargestellt an einer Ueberlagerungseinheit 58. Bevorzugt wird dies dadurch realisiert, dass die beiden Entladungselektroden 53/54 intermittierend über eine Choppereinheit 59 hochohmig/niederohmig verbunden werden, welche gestrichelt dargestellt ist. Dies erfolgt mit einer vorgegebenen fixen Repetitionsrate bzw. Duty-cycle und/oder bevorzugterweise dadurch, dass das Entstehen von Störentladungen im Prozessraum automatisch registriert wird und unmittelbar darauf, mit der Choppereinheit 59, die erwähnten Elektroden nach Bedarf niederohmig verbunden werden.

Diese Ueberlagerungstechnik, die, wie noch zu beschreiben sein wird, auch andernorts erfindungsgemäss eingesetzt wird, ist vollumfänglich in der EP-A-0 564 789 detailliert erläutert.

Bezüglich dieser eingesetzten Choppertechnik wird vollumfänglich auf die erwähnte Schrift verwiesen und diese diesbezüglich zum integrierten Bestandteil der vorliegenden Beschreibung erklärt.

In der Vakuumkammer 51 ist weiter eine Werkstückträgerelektrode 60 vorgesehen, welche z.B. bezüglich Elektrode 54 mittels einer DC-Quelle 62 auf negatives DC-Potential gelegt ist, wobei auch hier mittels Ueberlagerung der beschriebenen Art, vorzugsweise mittels einer Choppereinheit 64 genannter (59) Art, die Stabilität des Beschichtungsprozesses an der Werkstückträgerelektrode 60 sichergestellt wird. Bezüglich der elektrischen Potentiallegung von Kammergehäuse, den Elektroden 53, 54 und 60 sind dem Fachmann, auch.bezüglich Festlegung eines Referenzpotentials, nämlich von Massepotential, hinlänglich verschiedene Möglichkeiten bekannt.

Es wird weiter der Kammer 51 bzw. dem Prozessraum von einer Gastankanordnung 66 ein Reaktivgas G mit Kohlenstoff C und/oder Stickstoff $N_2$ und vorzugsweise weiter mit Wasserstoff H zugeführt. Dies nebst dem Entladungsarbeitsgas, üblicherweise Ar. Bevorzugterweise wird das Gas G durch gesteuerte Mischung zweier Gase $G_1$ und $G_2$ erzeugt, wie schematisch mit den steuerbaren Ventilen $V_1$ und $V_2$ dargestellt. Weisen die Gase, wie Propan und Butan oder Stickstoff und Ammoniak, unterschiedliche Stöchiometrieverhältnisse (Butan 2,5; Propan 2,7) auf, so kann durch die Steuerung unterschiedlicher Anteile der Gase $G_1/G_2$ in der Prozessatmosphäre das Verhältnis C/H oder N/H an der sich ablegenden $Si_xC_yH_z$- oder $Si_vN_wH_u$-Schicht gesteuert werden und damit, mittels zweier unabhängiger Parameter, C und H oder N und H, die Transmission $T_2$ und der Brechungswert $n_1$ an der entstehenden $Si_xC_yH_z$- oder $Si_vN_w$-$H_u$-Schicht.

Wird ein einziges Gas eingesetzt, so wird bevorzugterweise Propan eingesetzt für $Si_xC_yH_z$ und Stickstoff für $Si_vN_w$.

Heute wird für die Schichtherstellung Magnetronzerstäuben bevorzugt. Fig. 5 zeigt beispielsweise und schematisch eine Anlage hierfür. Dabei wird von einer Magnetronquelle 70 das Silicium in die Prozessatmosphäre des Vakuumrezipienten 71 freigesetzt. Die Magnetronelektrode 70 ist bezüglich der Werkstückträgerelektrode 73 über eine DC-Quelle 75 vorbeschriebener Art verbunden, wobei wiederum eine vorerläuterte Chopperanordnung 77 eingesetzt wird, gestrichelt dargestellt, als die bevorzugte Realisation der Ueberlagerung bei 78 der DC-Spannung und einer AC-Spannung, vorzugsweise einer Mf- oder Tf-Spannung, dabei vorzugsweise einer pulsierenden.

Sowohl in den Betriebsarten mit einer auch DC-betriebenen Entladung PL beim Ionenplattieren gemäss Fig. 4 wie auch insbesondere beim auf DC-Betrieb basierenden Zerstäuber nach Fig. 5 wird ein Siliciumtarget eingesetzt, welches n- oder p-dotiert ist, vorzugsweise mit Bor und/oder Phosphor. Bevorzugterweise ist der spezifische Widerstand des Targetmaterials aus dem dotierten Si, $\rho_{Si}$:

$$0,01 \Omega cm \leq \rho_{si} \leq 6 \Omega cm.$$

Vorzugsweise gilt:

$$0,4 \Omega cm \leq \rho_{si} \leq 0,6 \ \Omega cm.$$

Hiermit wird erreicht, dass das an sich schlecht leitende Silicium eine bessere Leitfähigkeit $ñ_{Si}^{-1}$ hat und sogar DC- oder vorzugsweise, wie erläutert, mit DC-Spannung und ihr überlagerter AC-Spannung zerstäubt werden kann, vorzugsweise mit dem Choppereinsatz.

Diese Arbeitsweise erlaubt einen kostengünstigen Betrieb bei hoher Abscheiderate, wobei das Silicium ohne unerwünschte Lichtbogenbildung und entsprechende Spritzerbildung, eine hohe Schichtqualität ergebend, abgestäubt wird.

Das Reaktivgas G wird als Einzelgas oder als Gasgemisch eingelassen, wie dies bereits anhand von Fig. 4 erläutert wurde. Die Schichten können mit der Magnetronquelle 70 in bekannter Weise, beispielsweise durch unmittelbares Plazieren des Substrates vor dem Target, abgeschieden werden oder auch durch Vorbeibewegen am Target, z.B. in linearen Durchlaufanlagen oder in Anlagen mit rotierenden, zylinderförmigen Werkstückträgern.

Bevor Resultate präsentiert werden, werden anschliessend, zusammenfassend, Vorteile des erfindungsgemässen Informationsträgers und des erfindungsgemässen Herstellverfahrens in bevorzugten Ausführungsformen zusammengestellt:

Informationsträger mit Zwischenlage:

- Durch Aufbau der Schicht 1 mit einer optischen Dicke, die im wesentlichen einer ungeradzahligen Anzahl $\lambda_o/4$ entspricht, wird eine geringe Zwischenlagendiken-Empfindlichkeit der Reflexion erzielt, gleichzeitig aber ermöglicht, die Transmission durch geringfügige Abweichungen (m -0.6) dieser Dimensionierung zu erhöhen.

- Bei einer gewählten Wellenlänge (vorzugsweise 635nm) der elektromagnetischen Strahlung für Aufbringen, insbesondere für Auslesen von Information an Grenzflächen, zwischen welchen sich mindestens eine erfindungsgemässe Zwischenlage mit Schicht 1 befindet, wird eine hohe Transmission $T_2$ der Zwischenlage und eine hohe Reflexion an deren Oberfläche erzielt (Fig. 1 bis 3).

- Die Transmission $T_2$ der vorgesehenen Schicht 1 ist für UV-Licht hoch ($\geq 10\%$), so dass aufgebrachte Lacke, die UV-härtbar sind, durch Strahlung durch die Schicht 1 hindurch mit hohem Wirkungsgrad härtbar sind.

- Die Haftung der Schicht 1 an abdeckenden Materialien mit C, wie insbesondere an Kunststoffen, insbesondere Polycarbonat oder PMMA, sowie an den erwähnten UV-härtbaren Laken ist hoch, weil auch das Schichtmaterial C umfasst.

- Insbesondere bei $Si_xC_yH_z$- oder $Si_vN_wH_u$-Schichtmaterialwahl ergeben sich, mit C- und H- oder N- und H-Anteilen, zwei unabhängige Parameter zur Einstellung von Transmission und Reflexion der Schicht 1 bzw. an der Zwischenlage.

- Die Zwischenlage mit der Schicht 1 eröffnet kostengünstige, einfach beherrschbare Herstellungsprozesse und deren Durchführung mit kostengünstigen Anlagen.

Herstellungsverfahren:

- Der Einsatz insbesondere von dotierten Siliciumtargets ist kostengünstig und einfach; die Targets sind einfach herstellbar.

- Durch Einsatz von C-, H- oder N-enthaltenden Gasen kommt relativ kostengünstiges und ungefährliches Gas zum Einsatz.

- Durch Einsatz einer DC-Beschichtungstechnik mit der erwähnten AC-Ueberlagerung, insbesondere bei der mit schlechtleitenden Materialien störbeschichtete oder beschichtete Anlageteile oder Werkstücke kurzzeitig niederohmig verbunden werden, entfallen teure leistungsstarke AC-Generatoren. Ueberschläge und Prozessinstabilitäten werden trotzdem, aber kostengünstig und technisch einfach realisierbar, effizient vermieden.

## 1. Beispiel:

Auf Polycarbonatsubstraten wurde eine $Si_xC_yH_z$-Schicht abgelegt. Hierzu wurde eine Anlage eingesetzt, wie sie prinzipiell in Fig. 5 dargestellt ist. Die Substrate waren auf einem Zylinderträger aufgebracht und wurden an einem Rechteckmagnetron vorbeibewegt. Der Substrat/Targetabstand betrug dabei 70mm.

| | |
|---|---|
| Targetmaterial: | Si(99,99%), p-dotiert (Bor), $\rho_{Si}$ = 0,5Ωcm; |
| Stromversorgung: | 10kW/DC mit Choppereinheit (77, Fig. 5); |
| Arbeitsgas: | Ar; |
| Reaktivgas: | Propan, $C_3H_8$; |
| Reaktivmode / Metallmode: | Regelung durch Plasmaemissionsmonitor-Messung und Eingriff auf Chopper (77) sowie auf Ar/$C_3H_8$-Flow controller (V1/V2 von Fig. 4); |
| Entladungsleistung: | 7kW; |
| Rotationsfrequenz der Werkstückträgerelektrode (73): | 0,5 Hz. |

In der nachfolgenden Tabelle sind für drei Chargen Nr. 2, 3, 4 die weiteren, für den Beschichtungsprozess eingestellten Prozessparameter spezifiziert.

| Charge | Leistung | Argon-Fluss | Gasdruck | Metallmode Spannung | Reaktivmode Spannung | Propan-Fluss | Flussverhältnis | Sputterzeit |
|--------|----------|-------------|----------|---------------------|----------------------|--------------|-----------------|-------------|
| | kW | sccm | e-3mbar | UMM<br>V | URM<br>V | qC3H8<br>sccm | qC3H8:qAR | s |
| 2 | 7 | 25.5 | 4 | 807 | 777-780 | 5.9 | 23.14% | 377 |
| 3 | 7 | 25.5 | 4 | 800 | 724 | 12 | 47.06% | 377 |
| 4 | 7 | 25.5 | 4 | 828 | 765 | 11.4 | 44.71% | 225 |

EP 0 762 406 B1

An den Chargen der Nr. 2, 3, 4 wurden folgende Werte gemessen:

| Charge | Brechwert bei 635nm | Extinktionskoeffizient bei 635nm | Reflexion bei 635 nm |
|--------|---------------------|----------------------------------|----------------------|
|        | n                   | k                                | %                    |
| 2      | 3.19                | 1.47                             | 38                   |
| 3      | 2.28                | 0.35                             | 13                   |
| 4      | 2.59                | 0.67                             | 23                   |

Bei den auf Polycarbonat aufgebrachten erfindungsgemässen $Si_xC_yH_z$-Schichten wurde in Charge Nr. 4, von der Luftseite her, bei 635nm, eine Reflexion von 40% gemessen. Der transmittierte Anteil durch den Polycarbonatträger einer Dicke von 1,2mm mit aufgebrachter erfindungsgemässer Schicht betrug 60% bei 635nm, entsprechend $T_2 \approx 100\%$, d.h. einer Absorption von praktisch 0%. Bei 360nm betrug die transmittierte Energie 12%. Bei den Chargen 2 bis 4, die oben spezifiziert sind, ergaben sich folgende Stöchiometrieverhältnisse:

| Chargen No. | Si | : | C | : | H | : | O |
|-------------|------|---|-------|---|-------|---|-------|
| no. 2 | 0.529 | : | 0.116 | : | 0.295 | : | 0.06 |
| no. 3 | 0.401 | : | 0.227 | : | 0.29 | : | 0.082 |
| no. 4 | 0.42 | : | 0.203 | : | 0.33 | : | 0.047 |

Es ergaben sich, mit Blick auf Fig. 1:

$$0,2 \leq R_2 \leq 0,4$$

und

$$0,2 \leq (R_1 \cdot T_2^2) \leq 0,4.$$

Als Bereich für den Brechungswert wird vorerst vorgeschlagen:

$2,59 \leq n_1 \leq 3,2$ für Polycarbonat-Substratmaterial.

Für den Extinktionskoeffizienten k schlagen wir vorerst vor:

$$k_{300nm} \leq 1,5 \text{ und}$$

und/oder $\quad k_{600\text{-}700nm} \leq 0,5,$
dabei insbesondere $\quad k_{600\text{-}700nm} \leq 0,1,$

und/oder $\quad k_{450\text{-}500nm} \leq 1.$

Durch Realisation eines Informationsträgers mit der Struktur gemäss Fig. 3 mittels eines Beschichtungsprozesses, wie er beschrieben wurde, wiesen die Strahlen $S_1$ bis $S_3$ ungefähr 20% der einfallenden Energie auf bei einer Absorption von höchstens 2% bei Strahlung einer Wellenlänge von $\lambda_s = 635nm$.

**2. Beispiel:**

Als Ergebnis des ersten, oben erwähnten Beispiels stellten wir fest, dass mit stöchiometrischen oder nahezu stöchiometrischen semitransparenten Schichten aus SiC Brechungswerte $n_1$ erreicht wurden, welche nicht eigentlich den Wert von 3,2 übersteigen, bei einer Wellenlänge von 633nm. Anderseits schien es zuerst nicht möglich, eine ausgeprägtere Unstöchiometrie einzusetzen und damit höhere Brechungswerte, weil angenommen wurde, dabei zu hohe k-Werte zu erhalten. Es schien weiter nicht möglich, ein Signal Spex von 25% für blaues Laserlicht bei 450nm zu realisieren.

Nichtsdestotrotz führten die Erfinder weitere Experimente durch, welche zeigten, dass Materialien mit höheren Brechungswerten erlauben würden, dünnere Schichten einzusetzen, so dass trotz erhöhter k-Werte der Materialien die Transparenzabnahme nicht entscheidend sein würde. Es wurden, wie nachfolgend gezeigt wird, Brechungswerte wesentlich über 4, bis zu 4,6 und insbesondere bei 4,2 erreicht, gleichzeitig mit k-Werten $k_{350nm} \leq 2,5$, $k_{600-700nm} \leq 0.5$ und $k_{450-500nm} \leq 1$.

Mit Einsatz von Si-Targetmaterial wurden Schichten mit hohem Brechwert realisiert, und zwar durch reaktives Sputtern in Stickstoff enthaltender Atmosphäre anstelle von Wasserstoff, Kohlenstoff, Gas, entsprechend Beispiel 1. Experimentieren an einer eher stöchiometrischen Version von $Si_xC_yH_z$ zeigte, dass es möglich ist, sogar bei 450nm 25% Signale von beiden Grenzflächen zu erhalten.

$Si_xC_yH_z$-, $Si_xC_y$-, $Si_vN_wH_u$- und $Si_vN_w$-Schichten wurden auf Polycarbonatsubstrate abgelegt. Obwohl eine Anlage, wie in Fig. 5 dargestellt, eingesetzt hätte werden können, wurde eine SDS 100-Anlage von Balzers eingesetzt, woran die Substrate bezüglich des Targets stationär gehalten werden.

| | |
|---|---|
| Substrat/Targetabstand: | 40mm |
| Ungefähres Reaktionsvolumen: | $5000cm^3$ |
| Targetmaterial: | wie in Beispiel 1. |
| Stromversorgung: | wie in Beispiel 1. |
| Arbeitsgas: | wie in Beispiel 1. |
| Reaktivgas: | Methan für $Si_xC_y$ und $Si_xC_yH_z$. |
| Stickstoff und Ammoniak für: | $Si_vN_w$ und $Si_vN_wH_u$. |
| Entladungsleistung: | 4kW. |

In der folgenden Tabelle sind vier typische Chargen dargestellt mit Bezug auf die Beschichtungsparameter, welche die bevorzugten Bereiche für digitale Video-Disk-Beschichtungen aus Siliciumcarbid oder Siliciumnitrid darstellen. Dabei sind Chargen mit den höchsten erreichten Brechungswerten dargestellt sowie Chargen mit den tiefsten, gerade noch einsetzbaren Brechungswerten.

Tabelle 1: Prozessparameter und resultierende n- und k-Werte

| Charge | Schicht | Fluss N2 | Fluss CH4 | Fluss Ar | Spannung v | n633nm | k633nm | k350nm | n450 | k450 |
|---|---|---|---|---|---|---|---|---|---|---|
| 6 | $Si_vN_w$ | 4 | 0 | 32 | 540 | 4.19 | .5 | 2.43 | | |
| 12 | $Si_vN_w$ | 14 | 0 | 32 | 542 | 3.02 | .18 | 1.01 | | |
| 42 | $Si_xC_y$ | 0 | 4 | 32 | 557 | 3.97 | .24 | 2.33 | 4.35 | 1 |
| 45 | $Si_xC_y$ | 0 | 16 | 32 | 555 | 2.81 | .03 | 0.95 | 3.04 | 0.33 |

Tabelle 2 zeigt gemessene und kalkulierte Resultate, die Reflexion-R- und die Transmission-T-Messungen wurden mittels eines Lambda-9-Spektralphotometers von Perkin Elmer auf Corning Testsubstraten durchgeführt. Von den R-T-Messungen wurden die n- und k-Werte berechnet. Von den n- und k-Werten wurde die optimale Dicke für höchstmögliche Signalwerte $S_1$ und $S_2$ von beiden Grenzflächen berechnet, durch Einsatz des obenerwähnten Film Star-Programmes. Die optimalen Indexwerte, welche die höchstmöglichen Signalwerte ergeben, liegen für SiC zwischen n = 3,97 und n = 2,81. Bei n = 3,13 und k = 0,06 ergeben sich Signale $S_1 = S_2 = 32,2\%$, d.h. lediglich 2,4% unter der theoretischen Grenze, wenn Al als hochreflektierende Abdeckung eingesetzt wird.

Tabelle 3 zeigt die entsprechenden Stöchiometrien für die postulierten Brechwert-Grenzwerte, wie sie für digitale Video-Disk-Anwendungen eingesetzt werden können.

Tabelle 2: R-T-Messungen in Luft mit maximal möglichen Signalen von den Grenzflächen $S_1$, $S_2$ für die entsprechenden Werte der optischen Konstanten n und k.

Rot-Laser-Resultate:

| Charge | Reflexion bei 633nm | Transmission bei 633nm | Gemessene Dicke | Berechnete optimale Dicke | Signal von 1. Grenzfläche | Signal von 2. Grenzfläche |
|---|---|---|---|---|---|---|
| | R | T | dm | dopt | S1 | S2 |
| | % | % | nm | nm | % | % |
| 6 | 62.2 | 23.2 | 35.1 | 15.2 | 25 | 25 |
| 12 | 47.8 | 41.8 | 51.3 | 48 | 28 | 28 |
| 42 | 63.4 | 28.1 | 39.1 | 18.5 | 29 | 29 |
| 45 | 46.3 | 51.5 | 57.4 | 56.3 | 26.2 | 40.8 |

Blau-Laser-Resultate:

| Charge | Reflexion bei 450nm | Transmission bei 450nm | Gemessene Dicke | Berechnete optimale Dicke | Signal von 1. Grenzfläche | Signal von 2. Grenzfläche |
|---|---|---|---|---|---|---|
| | R | T | dm | dopt | S1 | S2 |
| | % | % | nm | nm | % | % |
| 42 | 38 | 36.4 | 39.1 | 9.2 | 21 | 21 |
| 45 | 28 | 40.5 | 57.4 | 34 | 25 | 25 |

Tabelle 3: Stöchiometrie der Chargen, welche den einsetzbaren Bereich des Brechungswertes für DVD-Applikationen festlegen

| Charge | Si | O | N | C | H | n633nm | n450nm |
|---|---|---|---|---|---|---|---|
| | % | % | % | % | % | | |
| 6 | 78 | 5 | 11 | 2 | 4 | 4.19 | |
| 12 | 58.6 | 2 | 36.4 | 2 | 1 | 3.02 | |
| 42 | 70.4 | 7.8 | 0 | 8.7 | 13.1 | 3.97 | 4.35 |
| 45 | 49.4 | 4.2 | 0 | 23.8 | 22.6 | 2.81 | 3.04 |

Damit schlagen wir abschliessend als Bereich für den Brechungswert der Schicht gemäss vorliegender Erfindung vor:

$$2,59 \leq n_1 \leq 4,6, \text{ dabei insbesondere } 2,8 \leq n_1 \leq 3,2.$$

Für den Extinktionskoeffizienten k schlagen wir schliesslich vor:

$$k_{300nm} \leq 3,0 \text{ und/oder } k_{350nm} \leq 2,7$$

und/oder

$$k_{600-700nm} \leq 0,5, \text{ dabei insbesondere } \leq 0,1,$$

und/oder

$$k_{450-500nm} \leq 1.$$

Folgende Ziele wurden zusätzlich erreicht:

- Herstellung zu tiefen Kosten, weil durch Ausnützung der vorgeschlagenen Stöchiometrieverhältnisse äusserst dünne Schichten eingesetzt werden können, welche die Fertigungszeiten drastisch reduzieren;

- Abgleich mehrerer reflektierter Strahlen;

- Möglichkeit, die Signalpegel an die Vorgaben eines Lesegerätes anzupassen;

- Möglichkeit, die Signalpegel, welche erreicht werden, entsprechend der Schichtdickenverteilung, wie sie an einer spezifischen Fertigungsanlage realisierbar ist, anzupassen;

- erhöhte Haftung an Prozesskammerwänden und -maskierungen für metallähnliche Schichten, womit das bekannte "flaking-off"-Problem gelöst wird;

- vereinfachte Prozessbeherrschung dadurch, dass es möglich wird, den Prozess nahe am metallischen Mode zu führen. Je näher ein Reaktivprozess am metallischen Mode geführt werden kann, je geringer ist die Gefahr, dass der Prozess abrupt und unbeherrschbar in den Reaktivmode springt;

- der Einsatz von Stickstoff anstelle von Propan oder Methan reduziert zusätzlich vorzusehende Sicherheitsmassnahmen;

- es wird ermöglicht, 25%-Signale von zwei der erwähnten Grenzflächen zu erhalten, sogar mit blauem Laser bei 450nm.


**Patentansprüche**

1. Informationsträger, der durch Laserstrahlung bei mindestens einer gegebenen Wellenlänge $\lambda_s \leq 800$ nm beschreib- und/oder auslesbar ist und bei dem die Information durch örtliche Modulation mindestens einer Festkörpereigenschaft, von der die Reflexion der Strahlung (7) im Informationsträger abhängt, an mindestens zwei Festkörpergrenz-flächen ($3_o$, $3_u$) aufgebracht ist oder aufgebracht wird und zwischen den zwei Grenzflächen ($3_o$, $3_u$) eine Zwischenlage (3) vorhanden ist, die die Strahlung transmittiert ($T_2$), wobei die Zwischenlage (3) ein mindestens einschichtiges dielektrisches Schichtsystem (1) hat, welches eine optische Dicke (D) aufweist, die nach Massgabe des Ausdruckes $m \cdot \lambda_o/4$ dimensioniert ist, wobei $m \geq 1$, ganzzahlig und ungerade ist, und $\lambda_o$ die Wellenlänge der Strahlung in der mindestens einen dielektrischen Schicht (1) ist, für deren Brechungswert $n_1$ und für deren Extinktionskoeffizienten k gilt:

$$2,59 \leq n_1 \leq 4,6$$

$$k_{300} \leq 3,0,$$

und die optische Dicke (D) der dielektrischen Schicht dünner oder dicker ist, als sich für einen ganzzahligen Wert von m ergibt, entsprechend einer Erniedrigung des Wertes m um bis zu 0,6 bzw. einer Erhöhung um bis zu 0,2.

**2.** Informationsträger nach Anspruch 1, **dadurch gekennzeichnet, dass** das Schichtsystem mindestens überwiegend aus mindestens einem der folgenden Materialien besteht:

$Six_xC_y$, $Si_vN_w$, $Si_xC_yH_z$, $Si_vN_wH_u$, ZrN, HfN, TiN,

wobei die Variablen u, v, w, x, y, z ungleich 0 sind.

**3.** Informationsträger nach einem der Ansprüche 1 oder 2, **dadurch gekennzeichnet, dass** die örtlich modulierte Festkörpereigenschaft an mindestens einer der Grenzflächen die Dicke (D) der die Grenzfläche definierenden Materiallagen ist.

**4.** Informationsträger nach einem der Ansprüche 1 bis 3, **dadurch gekennzeichnet, dass** für $\lambda_s$ gilt:

$$400nm \leq \lambda_s$$

vorzugsweise

$$630nm \leq \lambda_s \leq 655nm,$$

vorzugsweise

$$633nm \leq \lambda \leq 650nm.$$

**5.** Informationsträger nach einem der Ansprüche 1 bis 4, **dadurch gekennzeichnet, dass** die Strahlungsreflexion an mindestens einer der Grenzflächen 20% bis 40% (beide Grenzen eingeschlossen) beträgt bei der gegebenen Strahlungswellenlänge.

**6.** Informationsträger nach Anspruch 5, **dadurch gekennzeichnet, dass** diese Reflexion für Strahlung bei einer ersten gegebenen Wellenlänge vorzugsweise von ca. 635nm oder ca. 650nm an der einen Grenzfläche gilt und für Strahlung bei einer zweiten gegebenen Wellenlänge vorzugsweise von ca. 785nm an der anderen Grenzfläche, wobei die Reflexion der Strahlung bei der zweiten Wellenlänge an der ersten Grenzfläche wesentlich tiefer ist als die Reflexion der Strahlung bei der ersten Wellenlänge.

**7.** Informationsträger nach Anspruch 6, **dadurch gekennzeichnet, dass** die Reflexion der Strahlung bei der zweiten Wellenlänge an der ersten Grenzfläche höchstens 10% beträgt.

**8.** Informationsträger nach einem der Ansprüche 1 bis 7, **dadurch gekennzeichnet, dass** der Extinktionskoeffizient k in mindestens einem der folgenden Bereiche liegt:

$$k_{300} \leq 1,5$$

und/oder

$$k_{350nm} \leq 2,7$$

und/oder

$$k_{500-700nm} \leq 0,5.$$

**9.** Informationsträger nach Anspruch 1, **dadurch gekennzeichnet, dass** die Zwischenlage (3) weiter eine Abstandsschicht (5), vorzugsweise eine Lackschicht oder Kleberschicht, umfasst.

**10.** Informationsträger nach einem der Ansprüche 1 bis 9, **dadurch gekennzeichnet, dass** eine Grenzfläche zwischen der Schicht (1) und einem Kunststoff gebildet ist, vorzugsweise an Polycarbonat oder PMMA, oder zwischen der Schicht (1) und einer Abstandsschicht (5), oder zwischen der Schicht (1) und einer hochreflektierenden Deckschicht, vorzugsweise aus Al, Au oder Ag, vorzugsweise aus Al.

**11.** Informationsträger nach Anspruch 1, **dadurch gekennzeichnet, dass** die eine Grenzfläche an einem Lack, vorzugsweise einem durch UV-Bestrahlung härtbaren Lack, gebildet ist.

**12.** Informationsträger nach einem der Ansprüche 1 bis 11, **dadurch gekennzeichnet, dass** die Schicht (1) mindestens ein Halbleiter-Dotiermaterial enthält, vorzugsweise Bor und/oder Phosphor.

**13.** Informationsträger nach einem der Ansprüche 1 bis 12, **dadurch gekennzeichnet, dass** die Schicht (1) C enthält und mindestens einseitig an einem Material anliegt, das ebenfalls C enthält.

**14.** Informationsträger nach einem der Ansprüche 1 bis 13, **dadurch gekennzeichnet, dass** er für den lesenden und/oder schreibenden Einsatz von Licht im blauen Spektralbereich ($400nm \leq \lambda_s \leq 500nm$) ausgelegt ist.

**15.** Informationsträger nach einem der Ansprüche 1 bis 14, **dadurch gekennzeichnet, dass** die Schicht (1) mindestens überwiegend aus
$Si_xC_y$ und/oder
$Si_xC_yH_z$ besteht,

| | |
|---|---|
| jedenfalls mit | $x \geq y$, |
| vorzugsweise mit | $x \geq 1,2y$, |
| vorzugsweise mit | $x \geq 2y$, |

wobei y und z ungleich 0 sind.

**16.** Informationsträger nach einem der Ansprüche 1 bis 15, **dadurch gekennzeichnet, dass** die Schicht (1) mindestens überwiegend aus
$Si_vN_w$ und/oder
$Si_vN_wH_u$ besteht,

| | |
|---|---|
| jedenfalls mit | $v \geq w$, |
| vorzugsweise mit | $v \geq 1,2w$, |
| vorzugsweise mit | $v \geq 1,6w$, |

wobei w und u ungleich 0 sind.

**17.** Informationsträger nach einem der Ansprüche 1 bis 15, **dadurch gekennzeichnet, dass** die Schicht (1) mindestens überwiegend aus
$Si_xC_yH_z$ besteht,
wobei gilt:

$$x \leq 0,8; \quad y \geq 0,05; \quad z \geq 0,1,$$

vorzugsweise

$$x \leq 0,52,$$

$$y \geq 0,1,$$

$$z \geq 0,2,$$

wobei x ungleich 0 ist.

**18.** Informationsträger nach einem der Ansprüche 1 bis 14, **dadurch gekennzeichnet, dass** die Schicht (1) mindestens überwiegend aus
$Si_vN_wH_u$ und/oder $Si_vN_w$ besteht
und gilt:

$$v \leq 0,8;$$

$$w \geq 0,05,$$

dabei vorzugsweise

$$w \geq 0,1,$$

wobei v und u ungleich 0 sind.

**19.** Informationsträger nach einem der Ansprüche 1 bis 14, worin die Schicht (1) mindestens überwiegend aus
$Si_xC_y$ und/oder $Si_xC_yH_z$ besteht
und gilt:

$$[0,445 : 0,262] \leq [x : y] \leq [0,775 : 0,078]$$

und/oder gilt:

$$[0,445 : 0,249] \leq [x : z] \leq [0,775 : 0,118]$$

und/oder gilt:

$$[0{,}078 : 0{,}249] \leq [y : z] \leq [0{,}262 : 0{,}118].$$

**20.** Informationsträger nach einem der Ansprüche 1 bis 14, wobei die Schicht mindestens überwiegend aus $Si_xC_yH_z$ besteht
und gilt:

$$x : y : z = 0{,}704 \ (\pm \ 10\%) : 0{,}087 \ (\pm \ 10\%) : 0{,}131 \ (\pm \ 10\%)$$

oder gilt:

$$x : y : z = 0{,}494 \ (\pm \ 10\%) : 0{,}238 \ (\pm \ 10\%) : 0{,}226 \ (\pm \ 10\%);$$

wobei $\pm$ 10% die statistische Streuung bei mehreren Messungen besagter Werte angeben.

**21.** Informationsträger nach einem der Ansprüche 1 bis 14, wobei die Schicht mindestens überwiegend aus $Si_vN_w$ und/oder $Si_vN_wH_u$ besteht
und gilt:

$$[0{,}527 : 0{,}401] \leq [v : w] \leq [0{,}858 : 0{,}099]$$

und/oder gilt:

$$[0{,}527 : 0{,}044] \leq [v : u] \leq [0{,}858 : 0{,}009]$$

und/oder gilt:

$$[0{,}099 : 0{,}044] \leq [w : u] \leq [0{,}401 : 0{,}009].$$

**22.** Informationsträger nach einem der Ansprüche 1 bis 14, wobei die Schicht mindestens überwiegend aus $Si_vN_w$ und/oder $Si_vN_wH_u$ besteht
und dabei gilt:

$$v : w = 0{,}78 \ (\pm \ 10\%) : 0{,}11 \ (\pm \ 10\%)$$

oder

$$v : w = 0{,}586 \ (\pm \ 10\%) : 0{,}364 \ (\pm \ 10\%),$$

wobei + 10% die statistische Streuung bei mehreren Messungen angibt.

**23.** Informationsträger nach einem der Ansprüche 1 bis 22 mit mindestens drei Grenzflächen auf einer Seite eines Trägersubstrates.

**24.** Informationsträger nach einem der Ansprüche 1 bis 23 mit einer optischen oder magnetooptischen Speicherkapazität von ca. 11GByte, vorzugsweise ca. 13GByte, pro Seite bei einem Trägerdurchmesser von 120mm.

**25.** Verfahren zur Herstellung eines Informationsträgers nach einem der Ansprüche 1 bis 24, an welchem Informationsträger die Information durch örtliche Modulation (5) mindestens einer Festkörpereigenschaft, von der die Reflexion elektromagnetischer Strahlung (7) einer gegebenen Wellenlänge $\lambda_s \leq 800$ nm abhängt, an mindestens zwei Festkörpergrenzflächen aufgebracht ist, oder aufgebracht wird und bei dem die mindestens zwei Grenzflächen (3o, 3u) zwischen sich eine Zwischenlage (3) haben, welche die Strahlung transmittiert ($T_2$) und die Zwischenlage eine dielektrische Schicht hat mit einem Brechungswert $n_1$ und einem Extinktionskoeffizienten k von

$$2,59 \leq n_1 \leq 4,6$$

$$k_{300} \leq 3,0,$$

und die dielektrische Schicht mit einer Dicke

$$D = m \cdot \lambda_o / 4,$$

worin m eine ganzzahlige, ungerade Zahl ist, erniedrigt um bis zu 0,6 bzw. erhöht um bis zu 0,2 und $\lambda_o$ die Wellenlänge der erwähnten Strahlung im Material der dielektrischen Schicht und unter Freisetzen von Si von einem Festkörper in die Prozessatmosphäre abgelegt wird.

**26.** Verfahren nach Anspruch 25, **dadurch gekennzeichnet, dass** man die dielektrische Schicht mindestens überwiegend aus $Si_xC_yH_z$ und/oder $Si_vN_wH_u$ herstellt durch einen reaktiven Vakuumbeschichtungsprozess und dass man durch Führen des Konzentrationsverhältnisses von C zu H und/oder von N zu H in einem Gas in der Prozessatmosphäre ein Optimum von hoher Schichttransmission und hohem Brechwert des Schichtmaterials einstellt.

**27.** Verfahren nach Anspruch 26, **dadurch gekennzeichnet, dass** man die Konzentrationen von C zu H und/oder von N zu H in der Prozessatmosphäre durch Steuerung, vorzugsweise Regelung der Zuführung mindestens zweier Gase mit unterschiedlichen C- zu H-Anteilen bzw. N- zu H-Anteilen separat steuert bzw. regelt.

**28.** Verfahren nach einem der Ansprüche 25 bis 27, **dadurch gekennzeichnet, dass** zwischen einem Substratträger und einer Gegenelektrode eine DC-Spannung angelegt wird, der eine AC-Spannung überlagert wird, vorzugsweise eine gepulste, vorzugsweise, dass man Träger sowie Gegenelektrode intermittierend niederohmig und hochohmig verbindet.

**29.** Verfahren nach einem der Ansprüche 25 bis 28, **dadurch gekennzeichnet, dass** die dielektrische Schicht durch reaktives Sputtern oder durch Ionenplattieren, vorzugsweise durch Magnetronsputtern, abgelegt wird.

**30.** Verfahren nach einem der Ansprüche 25 bis 29-, **dadurch gekennzeichnet, dass** die dielektrische Schicht durch reaktives Zerstäuben eines Targets aus n- oder p-dotiertem Si erstellt wird.

**Claims**

**1.** Information carrier on which the information can be written and/or read out by laser radiation at least at one predetermined wavelength $\lambda_s \leq 800$ nm, and onto which the information is applied or will be applied at least at two solid material interfaces ($3_o$, $3_u$) by local modulation of at least one characteristic of the solid material on which characteristic the reflection of the radiation (7) at the information carrier depends, an intermediate layer (3) transmitting ($T_2$) the radiation being provided between said two interfaces ($3_o$, $3_u$), said intermediate layer (3) having a dielectric layer system (1) with at least one layer, said layer system having an optical thickness (D) which is dimensioned in accordance with m $\lambda_o/4$, wherein m $\geq 1$ integer and uneven and wherein $\lambda_o$ designates the wavelength of the radiation in said at least one dielectric layer (1) having an index of refraction $n_1$ and an extinction coefficient k as follows:

$$2.59 \leq n_1 \leq 4.6$$

$$k_{300} \leq 3.0$$

and wherein the optical thickness (D) of said dielectric layer is thinner or thicker as resulting for an integer value of m, corresponding to a reduction of up to 0.6 of the value of m or to an increase of up to 0.2.

2. The information carrier according to claim 1, wherein said layer system consists at least predominantly of at least one of the following materials:

$Si_xC_y$, $Si_vN_w$, $Si_xC_yH_z$, $Si_vN_wH_u$, ZrN, HfN, TiN,

wherein there is valid u, v, w, x, y, z $\neq$ 0.

3. The information carrier according to claim 1 or 2, wherein said locally modulated characteristic of the solid material body at least at one of said interfaces is the thickness (D) of the material layers defining said interfaces.

4. The information carrier according to any of claims 1 to 3, wherein $\lambda_s$ is:

$$400 \text{ nm} \leq \lambda_s,$$

preferably

$$630 \text{ nm} \leq \lambda_s \leq 655 \text{ nm},$$

preferably

$$633 \text{ nm} \leq \lambda_s \leq 650 \text{ nm}.$$

5. The information carrier according to any of claims 1 to 4, wherein the reflection of radiation at at least one of said solid material interfaces is 20% to 40% (both limits included) for a predetermined wavelength of said radiation.

6. The information carrier according to claim 5, said reflection being valid for radiation for a first wavelength of preferably about 635 nm or 650 nm at a first of said solid material interfaces and for radiation for a second wavelength of preferably about 785 nm at the other interface, reflection of radiation of said second wavelength at said first solid material interface being significantly lower than of radiation of said first wavelength.

7. The information carrier according to claim 6, wherein said reflection of said radiation at said second wavelength and at said first solid material interface is 10% at most.

8. The information carrier according to any of claims 1 to 7, wherein the extinction coefficient k is in at least one of the following ranges:

$$k_{300} \leq 1.5$$

and/or

$$k_{350} \leq 2.7$$

and/or

$$k_{500-700} \leq 0.5.$$

9. The information carrier according to claim 1, wherein said intermediate layer (3) comprises a spacer layer (5), preferably a lacquer or glue layer.

10. The information carrier according to claim 1, wherein one of said solid material interfaces is formed between said layer (1) and a plastic material preferably of polycarbonate or PMMA or between said layer (1) and a spacer layer (5) or between said layer (1) and a high reflection cover layer, preferably of Al, Au or Ag, preferably of Al.

11. The information carrier according to claim 1, wherein one of said solid material interfaces is formed at a lacquer surface, preferably a lacquer hardenable by means of ultra-violet radiation.

12. The information carrier according to any of claims 1 to 11, wherein said layer (1) comprises at least one semiconductor doping material, preferably boron and/or phosphor.

13. The information carrier according to any of claims 1 to 12, wherein said layer (1) contains C and fits at least on one side against a material which contains C as well.

14. The information carrier according to any of claims 1 to 13, wherein radiation in the blue spectral range (400 nm $\leq \lambda_s \leq$ 500 nm) performs at least one of reading and writing of said information.

15. The information carrier according to any of claims 1 to 14, wherein said layer (1) comprises at least predominantly
$Si_x C_y$ and/or
$Si_x C_y H_z$,

in any case with $\quad x \geq y$
preferably with $\quad x \geq 1.2\,y$,
preferably with $\quad x \geq 2\,y$,

wherein y and z are different of 0.

16. The information carrier according to any of claims 1 to 15, wherein the layer (1) comprises at least predominantly
$Si_v N_w$ and/or
$Si_v N_w H_u$,

in any case with $\quad v \geq w$,

preferably with $\quad v \geq 1.2\,w$,

preferably with $\quad w \geq 1.6\,w$,

wherein w and u are different of 0.

17. The information carrier according to any of claims 1 to 15, wherein said layer (1) comprises at least predominantly
$Si_x C_y H_z$ and wherein there is valid

$$x \leq 0.8; \quad y \geq 0.05 \text{ and } z \geq 0.1,$$

preferably

$$x \leq 0.52,$$

$$y \geq 0.1,$$

$$z \geq 0.2,$$

wherein x is different of 0.

18. The information carrier according to any of claims 1 to 14, wherein said layer (1) comprises at least predominantly one of $Si_vN_wH_u$ and $Si_vN_w$ and wherein there is valid:

$$v \leq 0.8;$$

$$w \geq 0.05,$$

preferably

$$w \geq 0.1,$$

wherein v and u are different of 0.

19. The information carrier according to any of claims 1 to 14, wherein said layer (1) comprises at least predominantly one of $Si_xC_y$ and $Si_xC_yH_z$ and wherein there is valid:

$$[0,445 : 0,262] \leq [x : y] \leq [0,775 : 0,078]$$

and/or

$$[0,445 : 0,249] \leq [x : z] \leq [0,775 : 0,118]$$

and/or

$$[0,078 : 0,249] \leq [y : z] \leq [0,262 : 0,118].$$

20. The information carrier according to any of claims 1 to 14, wherein said layer at least predominantly consists of $Si_xC_yH_z$ and wherein there is valid:

$$x : y : z = 0,704 \ (\pm 10\%) : 0,087 \ (\pm 10\%) : 0,131 \ (\pm 10\%)$$

or

$$x : y : z = 0,494 \ (\pm 10\%) : 0,238 \ (\pm 10\%) : 0,226 \ (\pm 10\%),$$

wherein $\pm$ 10% indicates the statistic dispersion of multiple measurements of said values.

21. The information carrier according to any of claims 1 to 14, wherein said layer comprises at least predominantly one of $Si_vN_w$ and $Si_vN_wH_u$ and wherein there is valid:

$$[0,527 : 0,401] \leq [v : w] \leq [0,858 : 0,099],$$

and/or

$$[0,527 : 0,044] \leq [v : u] \leq [0,858 : 0,009],$$

and/or

$$[0,099 : 0,044] \leq [w : u] \leq [0,401 : 0,009].$$

22. The information carrier according to any of claims 1 to 14, wherein said layer comprises at least predominantly one of $Si_vN_w$ and $Si_vN_wH_u$ and wherein there is valid:

$$v : w = 0,78 \ (\pm 10\%) : 0,11 \ (\pm 10\%),$$

or

$$v : w = 0,586 \ (\pm 10\%) : 0,364 \ (\pm 10\%),$$

wherein $\pm$ 10% indicates stsatistic dispersion of multiple measurements.

23. The information carrier according to any of claims 1 to 22, wherein at least three of said solid material interfaces are provided on one side of a carrier substrate.

24. The information carrier according to any of claims 1 to 23, with an optical or magnetooptical information storage capacity per side of a carrier substrate of at least 11 GByte, preferably about 13 GByte, at a diameter of a circular carrier of 120 mm.

25. A method for manufacturing an information carrier in accordance with any of claims 1 to 24, on which information carrier the information is applied or will be applied at at least two solid material interfaces by local modulation (5) of at least one characteristic of the solid material on which characteristic the reflection of the electromagnetical radiation (7) of a predetermined wavelength $\lambda_s \leq 800$ nm depends, and on which said at least two interfaces ($3_o$, $3_u$) are provided between them with an intermediate layer (3) transmitting the radiation ($T_2$), said intermediate layer having a dielectric layer system with an index of refraction and an extinction coefficient of

$$2.59 \leq n_1 \leq 4.6$$

$$K_{300} \leq 3.0$$

and the dielectric layer system having a thickness

$$D = m \cdot \lambda_o/4$$

Wherein m is an odd integral, reduced by up to 0.6 or increased by up to 0.2 and $\lambda_o$ is the wavelength of said radiation in the material of the dielectric layer system, and which is led down into the process atmosphere by releasing Si of a solid material.

26. The method of claim 25, wherein said dielectric layer is manufactured at least predominantly of $Si_xC_yH_z$ and/or $Si_vN_wH_u$ by a reactive vacuum coating process and wherein by guiding the concentration ratio of C to H and/or of N to H in a gas in the process atmosphere is adjusting an optimum of high layer transmission and high refraction value of the layer material.

27. The method of claim 26, wherein the concentration of C to H and/or N to H in the process atmosphere is separately controlled, preferably by controlling the feed of at least two gases with different quotes of C to H or N to H.

28. The method of any of claims 25 to 27, wherein a DC voltage is applied between a substrate carrier and a counter electrode, superimposed by an AC voltage, preferably a pulsed voltage, preferably by connecting the carrier and the counterelectrode intermittently with low or high resistance.

29. The method of any of claims 25 to 28, wherein said dielectric layer is deposited by reactive sputtering or by ion plating, preferably by magnetosputtering.

30. The method of any of claims 25 to 29, wherein the dielectric layer is produced by reactive sputtering of a target of n- or p-doted Si.

**Revendications**

1. Support d'information sur lequel l'information peut être inscrite et/ou extraite au moyen d'une radiation laser à au moins une longueur d'onde prédéterminée $\lambda_s \leq 800$ nm et sur lequel l'information est ou sera appliquée à au moins deux interfaces d'un corps solide ($3_o$, $3_u$) par modulation locale d'au moins une caractéristique du corps solide dont dépend la réflexion de la radiation (7) dans le support d'information, une couche intermédiaire (3) transmettant la radiation ($T_2$) étant prévue entre les deux interfaces ($3_o$, $3_u$), cette couche intermédiaire (3) ayant un système de couches diélectric (1) avec au moins une couche et présentant une épaisseur optique (D) qui est dimensionnée selon l'expression m · $\lambda_o/4$, dans laquelle m ≥ 1, entier et impair et $\lambda_o$ est la longueur d'onde de la radiation dans ladite au moins une couche diélectrique (1) ayant un indice de réfraction $n_1$ et un coéfficient d'extinction k comme suit:

$$2.59 \leq n_1 \leq 4.6$$

$$k_{300} \leq 3.0$$

et l'épaisseur optique (d) de la couche diélectrique étant plus mince ou plus épaisse comme il résulte d'une valeur entière de m, correspondant à une réduction de la valeur m jusqu'à 0.6 ou une augmentation jusqu'à 0.2 respectivement.

2. Support d'information selon la revendication 1, **caractérisé en ce que** ledit système de couches consiste au moins en majorité au moins un des matériaux suivants :

$Si_xC_y$, $Si_vN_w$, $Si_xC_yH_z$, $Si_vN_wH_u$, ZrN, HfN, TiN,

avec les variables u, v, w, x, y, z étant différent de 0.

3. Support d'information selon l'une des revendications 1 ou 2, **caractérisé en ce que** ladite caractéristique du corps solide modulée localement à au moins une interface est l'épaisseur (D) des couches de matériaux définissant l'interface.

4. Support d'information selon l'une des revendications 1 à 3, **caractérisé en ce que** la valeur pour $\lambda_s$ est:

$$400 \text{ nm} \leq \lambda_s,$$

de préférence

$$630 \text{ nm} \leq \lambda_s \leq 655 \text{ nm},$$

de préférence

$$633 \text{ nm} \leq \lambda_s \leq 650 \text{ nm}.$$

5. Support d'information selon l'une des revendications 1 à 4, **caractérisé en ce que** la réflexion de la radiation à la longueur d'onde donnée sur au moins une des interfaces est de 20% à 40% (les deux valeurs limites comprises).

6. Support d'information selon la revendication 5, **caractérisé en ce que** ladite réflexion de la radiation à une première longueur d'onde donnée, de préférence d'environ 635 nm ou d'environ 650 nm, est valable sur l'une des interfaces et pour une radiation à une seconde longueur d'onde donnée, de préférence d'environ 785 nm, sur l'autre interface, la réflexion de la radiation à la seconde longueur d'onde sur la première interface étant essentiellement plus faible que la réflexion de la radiation à la première longueur d'onde.

7. Support d'information selon la revendication 6, **caractérisé en ce que** la réflexion de la radiation à la seconde longueur d'onde sur la première interface est au maximum 10%.

8. Support d'information selon l'une des revendications 1 à 7, **caractérisé en ce que** le coefficient d'extinction k se trouve au moins dans une des zones suivantes :

$$k_{300} \leq 1.5$$

et/ou

$$k_{350} \leq 2.7$$

et/ou

$$k_{500-700} \leq 0.5.$$

**9.** Support d'information selon la revendication 1, **caractérisé en ce que** la couche intermédiaire (3) comprend en outre une couche d'espacement (5), de préférence une couche de laque ou une couche d'adhésif.

**10.** Support d'information selon l'une des revendications 1 à 9, **caractérisé en ce qu'**une interface est formée entre la couche (1) et une matière plastique, de préférence un polycarbonate ou PMMA, ou entre la couche (1) et une couche d'espacement (5) ou entre la couche (1) et couche de recouvrement à haut pouvoir de réflexion, de préférence en Al, Au ou Ag, de préférence en Al.

**11.** Support d'information selon la revendication 1, **caractérisé en ce que** l'une des interfaces est formée sur une laque, de préférence une laque durcissable par des rayons UV.

**12.** Support d'information selon l'une des revendications 1 à 11, **caractérisé en ce que** la couche (1) contient au moins un matériel de dotation pour semi-conducteurs, de préférence du bor et/ou du phosphore.

**13.** Support d'information selon l'une des revendications 1 à 12, **caractérisé en ce que** la couche (1) contient du C et contacte au moins d'un côté un matériau qui contient également du C.

**14.** Support d'information selon l'une des revendications 1 à 13, **caractérisé en ce qu'**il est conçu pour la mise en action de la lecture et/ou de l'inscription par une lumière dans le spectre bleu ($400\ \text{nm} \leq \lambda_s \leq 500\ \text{nm}$).

**15.** Support d'information selon l'une des revendications 1 à 14, **caractérisé en ce que** la couche (1) contient au moins en majorité du
$Si_xC_y$ et/ou du
$Si_xC_yH_z$,

| | |
|---|---|
| avec | $x \geq y$ |
| de préférence | $x \geq 1.2\ y$, |
| de préférence | $x \geq 2\ y$, |

avec y et z différent de 0.

**16.** Support d'information selon l'une des revendications 1 à 15, **caractérisé en ce que** la couche (1) contient au moins en majorité du
$Si_vN_w$ et/ou
$Si_vN_wH_u$,

| | |
|---|---|
| avec | $v \geq w$, |
| de préférence avec | $v \geq 1.2\ w$, |
| de préférence avec | $v \geq 1.6\ w$, |

avec w et u différent de 0.

**17.** Support d'information selon l'une des revendications 1 à 15, **caractérisé en ce que** la couche (1) contient au moins en majorité du $Si_xC_yH_z$,

avec

$$x \leq 0,8; \quad y \geq 0,05; \quad z \geq 0,1,$$

de préférence

$$x \leq 0,52,$$

$$y \geq 0,1,$$

$$z \geq 0,2,$$

avec x différent de 0.

18. Support d'information selon l'une des revendications 1 à 14, **caractérisé en ce que** la couche (1) contient au moins en majorité du
$Si_vN_wH_u$ et/ou $Si_vN_w$
avec

$$v \leq 0,8;$$

$$w \geq 0,05,$$

de préférence

$$w \geq 0,1,$$

avec v et u différent de 0.

19. Support d'information selon l'une des revendications 1 à 14, **caractérisé en ce que** la couche (1) contient au moins en majorité du
$Si_xC_y$
et/ou $Si_xC_yH_z$
avec:

$$[0,445 : 0,262] \leq [x : y] \leq [0,775 : 0,078]$$

et/ou avec

$$[0,445 : 0,249] \leq [x : z] \leq [0,775 : 0,118]$$

et/ou avec

$$[0,078 : 0,249] \leq [y : z] \leq [0,262 : 0,118].$$

20. Support d'information selon l'une des revendications 1 à 14, **caractérisé en ce que** la couche contient au moins en majorité du
$Si_xC_yH_z$
avec:

$$x : y : z = 0,704 \; (\pm 10\%) : 0,087 \; (\pm 10\%) : 0,131 \; (\pm 10\%)$$

ou avec:

$$x : y : z = 0,494 \; (\pm 10\%) : 0,238 \; (\pm 10\%) : 0,226 \; (\pm 10\%),$$

le chiffre $\pm$ 10% indiquant la dispersion statistique lors de mesures multiples des valeurs.

21. Support d'information selon l'une des revendications 1 à 14, **caractérisé en ce que** la couche contient au moins en majorité du
$Si_vN_w$ et/ou $Si_vN_wH_u$
avec:

$$[0,527 : 0,401] \leq [v : w] \leq [0,858 : 0,099],$$

et/ou avec

$$[0,527 : 0,044] \leq [v : u] \leq [0,858 : 0,009],$$

et/ou avec

$$[0,099 : 0,044] \leq [w : u] \leq [0,401 : 0,009].$$

22. Support d'information selon l'une des revendications 1 à 14, **caractérisé en ce que** la couche contient au moins en majorité du
$Si_vN_w$ et/ou $Si_vN_wH_u$
avec

$$v : w = 0,78 \; (\pm 10\%) : 0,11 \; (\pm 10\%),$$

ou

$$v : w = 0,586 \ (\underline{+} \ 10\%) : 0,364 \ (\underline{+} \ 10\%),$$

le chiffre $\pm$ 10% indiquant la dispersion statistique lors de mesures multiples.

23. Support d'information selon l'une des revendications 1 à 22, avec au moins trois interfaces d'un côte d'un substrat de support.

24. Support d'informations selon l'une des revendications 1 à 23, avec un capacité de mémoire optique ou magnétooptique d'environ 11 GByte, de préférence environ 13 GByte, par page avec un diamètre du support de 120 mm.

25. Procédé de fabrication d'un support d'information selon l'une des revendications 1 à 24, sur lequel support l'information est appliquée ou sera appliquée sur au moins deux interfaces d'un corps solide par modulation (5) locale d'au moins une caractéristique du corps solide de laquelle dépend la réflexion d'une radiation (7) électromagnétique d'une longueur d'onde prédéterminée $\lambda_s \leq 800$ nm, lesdites au moins deux interfaces ($3_o$, $3_u$) ayant entre elles une couche intermédiaire (3) qui transmet ($T_2$) la radiation, avec ladite couche intermédiaire étant munie d'une couche diélectrique avec un indice de réfraction $n_1$ et un coefficient d'extinction k de

$$2.59 \leq n_1 \leq 4.6$$

$$K_{300} \leq 3.0$$

et la couche diélectrique ayant une épaisseur

$$D = m \cdot \lambda_o/4$$

où m est un nombre impair entier, réduit jusqu'à 0.6 ou augmenté jusqu'à 0.2 et $\lambda_o$ la longueur d'onde de ladite radiation, dans le matériel de la couche diélectrique et est déposée dans l'atmosphère du procédé en libérant du Si d'un corps solide.

26. Procédé selon la revendication 25, **caractérisé en ce que** l'on produit par un procédé de recouvrement sous vide ladite couche diélectrique à partir au moins en majorité de $Si_xC_yH_z$ et/ou $Si_vN_wH_u$, et **en ce qu'**en guidant le rapport de concentration de C à H et/ou de N à H dans un gaz on règle dans l'atmosphère du procédé un optimum de haute transmission de la couche et une haute valeur de réfraction du matériel de la couche.

27. Procédé selon la revendication 26, **caractérisé en ce que** l'on règle séparément la concentration de C à H et/ou de N à H dans l'atmosphère du procédé par commande, de préférence par réglage de l'amené d'au moins deux gaz avec des rapports différents C à H et N à H.

28. Procédé selon l'une des revendications 25 à 27, **caractérisé en ce que** l'on établi un voltage DC entre un support de substrat et une contre-électrode, et on lui superpose un voltage AC, de préférence un voltage pulsé, de préférence en reliant de manière intermittente à basse et haute résistance le support et la contre-électrode.

29. Procédé selon l'une des revendications 25 à 28, **caractérisé en ce que** la couche diélectrique est déposé par sputtering ou par platinage ionique, de préférence par magnéto-sputtering.

30. Procédé selon l'une des revendications 25 à 29, **caractérisé en ce que** la couche diélectrique est produite par pulvérisation réactive d'un target Si doté en n ou p.

FIG. 1

FIG. 2

FIG. 3

33

FIG. 4

FIG. 5